# EUROPEAN PATENT APPLICATION

(11) **EP 4 651 665 A1**
(43) Date of publication of application: **19.11.2025**
(21) Application number: 25161973.0
(22) Date of filing: 05.03.2025
(51) Int. Cl.: H10B 12/00

(54) **SEMICONDUCTOR DEVICE**

(30) Priority: 14.05.2024 KR 20240063085
(71) Applicant: Samsung Electronics Co., Ltd., Suwon-si, Gyeonggi-do 16677 (KR)
(72) Inventor: KIM, Tae Yun, 16677 Suwon-si (KR); SONG, Jae Joon, 16677 Suwon-si (KR); SONG, Jun Hwa, 16677 Suwon-si (KR); HA, Heon Jun, 16677 Suwon-si (KR)
(74) Representative: Marks & Clerk LLP

(57) **Abstract**

There is provided a semiconductor device having improved integration density and electrical characteristics. The semiconductor device includes a first peri-gate structure on a substrate, an active pattern that is spaced apart from the substrate in a first direction and includes a first surface and a second surface opposite to each other in the first direction, a peri-active pattern that is spaced apart from the substrate in the first direction and includes a first surface and a second surface opposite to each other in the first direction, a second peri-gate structure on the first surface of the peri-active pattern, a bit line that is electrically connected to the first surface of the active pattern and extends in a second direction intersecting the first direction, and a data storage pattern electrically connected to the second surface of the active pattern.

## Description

### BACKGROUND OF THE INVENTION

The present disclosure relates to a semiconductor device, and more specifically, to a semiconductor device including a vertical channel transistor (VCT).

It is helpful to increase the degree of integration of a semiconductor memory device to satisfy excellent performance and low price requested by consumers. In the case of the semiconductor memory device, because the degree of integration is an important factor in determining the price of a product, an increased degree of integration is particularly helpful.

**In** the case of a two-dimensional or planar semiconductor memory device, the degree of integration is mainly determined by an area occupied by unit memory cells, and is therefore greatly affected by the level of a fine pattern formation technique. However, since expensive apparatuses are needed to miniaturize the pattern, the degree of integration of the two-dimensional semiconductor memory device is increasing, but is still limited. Accordingly, semiconductor memory devices including vertical channel transistors whose channels extend in a vertical direction have been proposed.

### SUMMARY OF THE INVENTION

Aspects of the present disclosure provide a semiconductor device having improved integration density and electrical characteristics.

However, aspects of the present disclosure are not limited to the ones set forth herein. The above and other aspects of the present disclosure will become more apparent to one of ordinary skill in the art to which the present disclosure pertains by referencing the detailed description of the present disclosure given below.

According to some aspects of the present disclosure, there is provided a semiconductor device comprising an active pattern that includes a first surface and a second surface opposite to each other in a first direction, a peri-active pattern that includes a first surface and a second surface opposite to each other in the first direction, wherein the peri-active pattern is spaced apart from the active pattern in a second direction intersecting the first direction, a bit line that is electrically connected to the first surface of the active pattern and extends in the second direction, a data storage pattern electrically connected to the second surface of the active pattern, and a first peri-gate structure on the first surface of the peri-active pattern.

According to some aspects of the present disclosure, there is provided a semiconductor device comprising a first peri-gate structure on a substrate, an active pattern that is spaced apart from the substrate in a first direction and includes a first surface and a second surface opposite to each other in the first direction, a peri-active pattern that is spaced apart from the substrate in the first direction and includes a first surface and a second surface opposite to each other in the first direction, a second peri-gate structure on the first surface of the peri-active pattern, a bit line that is electrically connected to the first surface of the active pattern and extends in a second direction intersecting the first direction, and a data storage pattern electrically connected to the second surface of the active pattern.

According to some aspects of the present disclosure, there is provided a semiconductor device comprising an active pattern that is spaced apart from a substrate in a first direction and includes a first surface and a second surface opposite to each other in the first direction, a peri-active pattern that is spaced apart from the substrate in the first direction and includes a first surface and a second surface opposite to each other in the first direction, a bit line that is electrically connected to the first surface of the active pattern, extends in a second direction intersecting the first direction, and includes a conductive bit line comprising a conductive material, a data storage pattern electrically connected to the second surface of the active pattern, a peri-gate structure that is on the first surface of the peri-active pattern and includes a peri-gate electrode, wherein a thickness of the peri-gate electrode is equal to a thickness of the conductive bit line, a peri-field insulating film in contact with a sidewall of the peri-active pattern, wherein the sidewall of the peri-active pattern connects the first surface of the peri-active pattern to the second surface of the peri-active pattern, a peri-contact plug electrically connected to the peri-gate structure, a peri-field through plug that extends into the peri-field insulating film, a peri-wiring line on the first surface of the peri-active pattern and electrically connected to the peri-contact plug and the peri-field through plug, and a peri-connecting structure on the substrate and electrically connected to the peri-wiring line.

At least some of the above and other features of the invention are set out in the claims.

### BRIEF DESCRIPTION OF DRAWINGS

The above and other aspects and features of the present disclosure will become more apparent by describing in detail example embodiments thereof with reference to the attached drawings, in which:
FIG. 1 is a layout diagram of a semiconductor device according to some embodiments.
FIG. 2 is a layout diagram of a boundary portion between a cell array region and a peripheral circuit region of the semiconductor device of FIG. 1.
FIG. 3 is a cross-sectional view taken along line A-A of FIG. 2.
FIG. 4 is a cross-sectional view taken along lines B-B and C-C of FIG. 2.
FIG. 5 is an enlarged view of a portion P of FIG. 3.
FIG. 6 is an enlarged view of a portion Q of FIG. 3.
FIG. 7 is a diagram for explaining a semiconductor device according to some embodiments.
FIGS. 8 to 10 are diagrams for explaining a semiconductor device according to some embodiments.
FIGS. 11 and 12 are diagrams for explaining a semiconductor device according to some embodiments.
FIGS. 13 and 14 are diagrams for explaining a semiconductor device according to some embodiments.
FIGS. 15 to 18 are diagrams for explaining a semiconductor device according to some embodiments, respectively.
FIGS. 19 to 26 are intermediate stage diagrams for explaining a method for fabricating a semiconductor device according to some embodiments.
FIGS. 27 to 30 are intermediate stage diagrams for explaining a method for fabricating a semiconductor device according to some embodiments.
FIGS. 31 to 34 are intermediate stage diagrams for explaining a method for fabricating a semiconductor device according to some embodiments.

### DETAILED DESCRIPTION

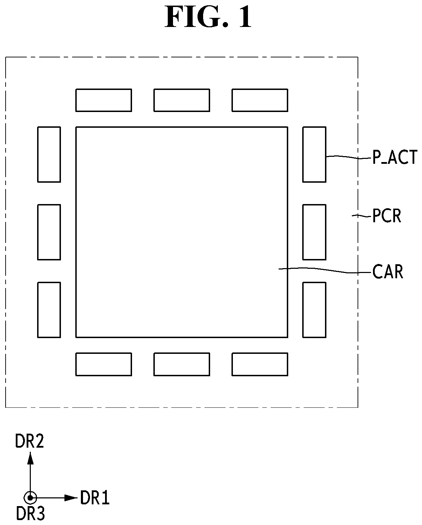

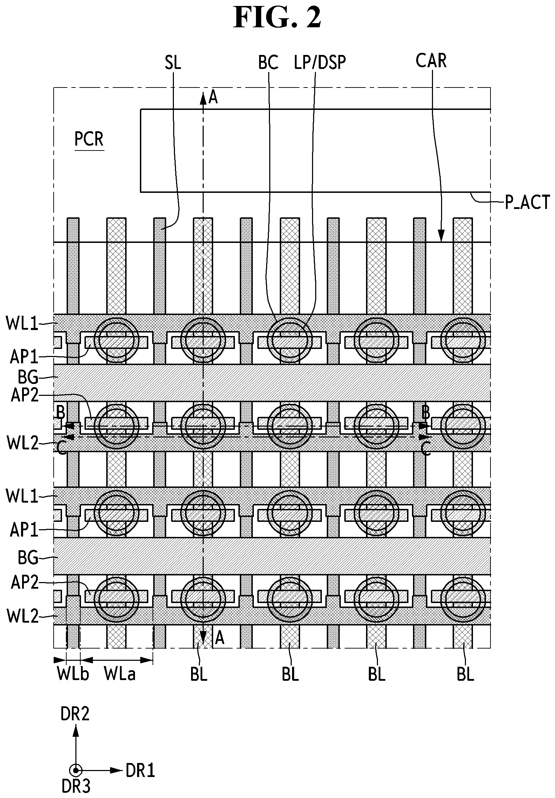

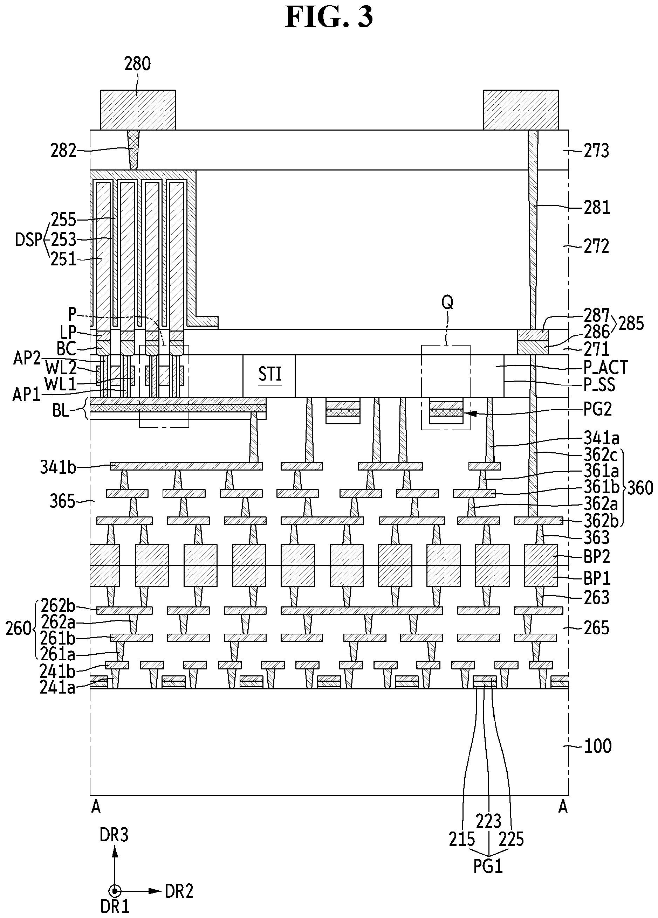

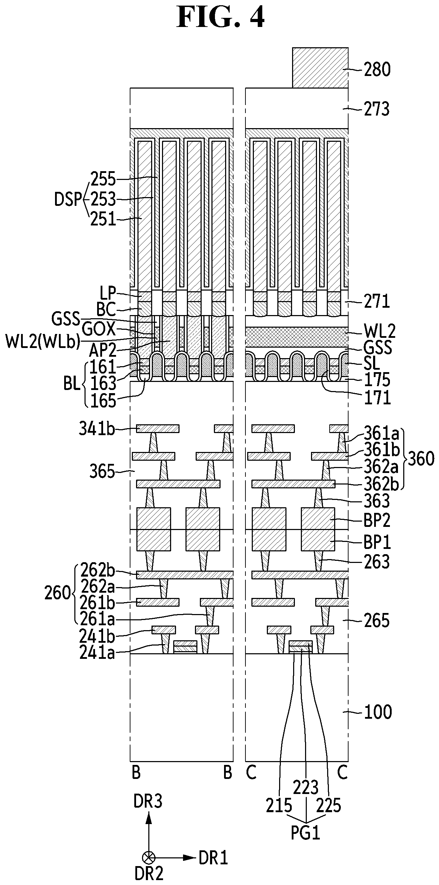

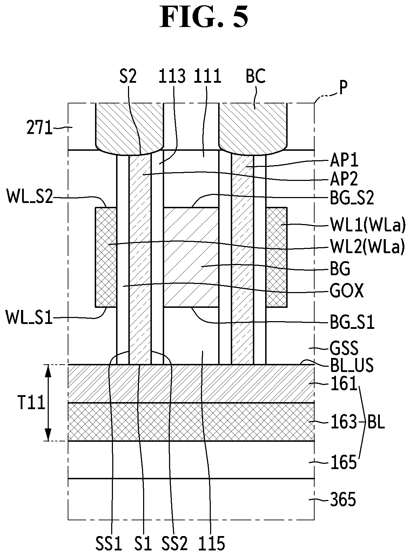

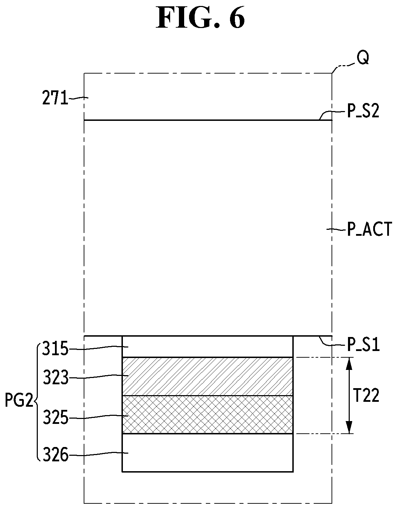

FIG. 1 is a layout diagram of a semiconductor device according to some embodiments. FIG. 2 is a layout diagram of a boundary portion between a cell array region and a peripheral circuit region of the semiconductor device of FIG. 1. FIG. 3 is a cross-sectional view taken along line A-A of FIG. 2. FIG. 4 is a cross-sectional view taken along lines B-B and C-C of FIG. 2. FIG. 5 is an enlarged view of a portion P of FIG. 3. FIG. 6 is an enlarged view of a portion Q of FIG. 3.

The semiconductor device according to example embodiments of the present disclosure may include memory cells including a vertical channel transistor (VCT).

Referring to FIGS. 1 to 6, the semiconductor device according to some embodiments may include a first peri-gate structure PG1, a second peri-gate structure PG2, peri-active patterns P_ACT, bit lines BL, word lines WL1 and WL2, back gate electrodes BG, a shielding conductive pattern SL, active patterns AP1 and AP2, and data storage patterns DSP.

The first substrate 100 may be a silicon substrate, or may include other materials, for example, but not limited to, silicon germanium, indium antimonide, lead telluride, indium arsenide, indium phosphide, gallium arsenide or gallium antimonide.

The first substrate 100 may include a cell array region CAR in which a data storage pattern DSP is disposed, and a peripheral circuit region PCR defined around the cell array region CAR. A peri-field insulating film STI may be disposed on the peripheral circuit region PCR of the first substrate 100. From viewpoint of a plan view, the peri-field insulating film STI may define the cell array region CAR of the first substrate 100.

A peri-active pattern P_ACT may be disposed on the peripheral circuit region PCR of the first substrate 100. The peri-active pattern P_ACT may be spaced apart from the first substrate 100 in a third direction DR3. The peri-active pattern P_ACT may not be in contact with the first substrate 100.

From viewpoint of a plan view, the peri-active patterns P_ACT may be disposed around the cell array region CAR. The peri-active pattern P_ACT may be disposed to be spaced apart from the cell array region CAR in a first direction DR1 or a second direction DR2. The peri-active pattern P_ACT may be spaced apart from the first active pattern AP1 and the second active pattern AP2 disposed in the cell array region CAR in the first direction DR1 or the second direction DR2. The peri-active pattern P_ACT does not overlap the first active pattern AP1 and the second active pattern AP2 in the third direction DR3. As used herein, "an element A overlaps an element B in a direction X" (or similar language) means that there is at least one straight line that extends in the direction X and intersects both the elements A and B.

For example, the peri-field insulating film STI may be disposed around the peri-active pattern P_ACT. From viewpoint of a plan view, the peri-field insulating film STI may be on (e.g., may cover) an outer edge of the peri-active pattern P_ACT. The peri-active pattern P_ACT may include a first surface P_S1 and a second surface P_S2 that are opposite to each other in the third direction DR3. The peri-active pattern P_ACT may include a side wall P_SS that connects the first surface P_S1 of the peri-active pattern and the second surface P_S2 of the peri-active pattern. The peri-field insulating film STI may be on (e.g., may cover) the side wall P_SS of the peri-active pattern. For example, the peri-field insulating film STI may be in contact with the side wall P_SS of the peri-active pattern.

The first peri-gate structure PG1 may be disposed on the first substrate 100. For example, the first peri-gate structure PG1 may be disposed on the upper surface of the first substrate 100. The first peri-gate structure PG1 may be disposed over the cell array region CAR and the peripheral circuit region PCR. In other words, a part of the first peri-gate structure PG1 may be disposed in the cell array region CAR of the first substrate 100, and the rest of the first peri-gate structure PG1 may be disposed in the peripheral circuit region PCR of the first substrate 100.

The first peri-gate structure PG1 may be included in a sensing transistor, a transfer transistor, a drive transistor, etc. It goes without saying that the types of transistors of the peripheral circuit disposed in the cell array region CAR and the peripheral circuit region PCR may vary depending on the design and layout of the semiconductor device.

The first peri-gate structure PG1 may include a first peri-gate insulating film 215, a first peri-lower conductive pattern 223, and a first peri-upper conductive pattern 225. The first peri-gate insulating film 215 may include a silicon oxide film, a silicon oxynitride film, a high dielectric constant insulating film having a higher dielectric constant than the silicon oxide film, or a combination thereof. The high dielectric constant insulating film may include, for example, but is not limited to, at least one of a metal oxide, a metal oxynitride, a metal silicon oxide, or metal silicon oxynitride.

The first peri-lower conductive pattern 223 and the first peri-upper conductive pattern 225 may each include a conductive material. The first peri-gate structure PG1 may include a first peri-gate electrode including a conductive material. The first peri-gate electrode may include a first peri-lower conductive pattern 223 and a first peri-upper conductive pattern 225. For example, the first peri-lower conductive pattern 223 and the first peri-upper conductive pattern 225 may each include at least one of a doped semiconductor material, a conductive metal nitride, a conductive metal silicon nitride, a metal carbonitride, a conductive metal silicide, a conductive metal oxide, a two-dimensional (2D) material, or a metal. In the semiconductor device according to some embodiments, the two-dimensional material may be a metallic material and/or a semiconductor material. The two-dimensional material may include a 2D allotrope or a 2D compound, and may include, but is not limited to, at least one of graphene, molybdenum disulfide (MoS₂), molybdenum diselenide (MoSe₂), tungsten diselenide (WSe₂), or tungsten disulfide (WS₂). That is, since the above-mentioned two-dimensional materials are only listed as an example, the two-dimensional materials that may be included in the semiconductor device of the present disclosure are not limited by the above-mentioned materials. Although the first peri-gate structure PG1 is shown to include a plurality of conductive patterns, the present disclosure is not limited thereto.

Although not shown, a peri-gate spacer may be disposed on a side wall of the first peri-gate structure PG1. The peri-gate spacer includes an insulating material. In addition, the first peri-gate structure PG1 may further include a first peri-gate mask pattern disposed on the first peri-upper conductive pattern 225. The first peri-gate mask pattern is made up of an insulating material.

A first peri-interlayer insulating film 265 is disposed on the first substrate 100. The first peri-interlayer insulating film 265 includes an insulating material.

A first peri-contact plug 241a and a first peri-wiring line 241b may be disposed in the first peri-interlayer insulating film 265. The first peri-contact plug 241a may be connected to a first source/drain region disposed on at least one side of the first peri-gate structure PG1. For example, the first source/drain region may be, but is not limited to, a region in which the first substrate 100 is doped with impurities. Although not shown, the first peri-contact plug 241a may be connected to the first peri-gate gate electrodes 223 and 225 of the first peri-gate structure PG1. The first peri-wiring line 241b may be disposed on the first peri-contact plug 241a. The first peri-wiring line 241b is connected to the first peri-contact plug 241a. For example, the first peri-wiring line 241b may be a wiring line that is closest to the first peri-gate structure PG1 in the third direction DR3.

Although the first peri-contact plug 241a and the first peri-wiring line 241b are shown as being different films, the present disclosure is not limited thereto. In some embodiments, a boundary between the first peri-contact plug 241a and the first peri-wiring line 241b may not be distinguished. The first peri-contact plug 241a and the first peri-wiring line 241b each include a conductive material.

A first peri-connecting structure 260 may be disposed on the first peri-wiring line 241b. The first peri-connecting structure 260 may be connected to the first peri-wiring line 241b. The first peri-connecting structure 260 may be disposed in the first peri-interlayer insulating film 265.

The first peri-connecting structure 260 may include first peri-connecting wirings 261b and 262b and first peri-connecting vias 261a and 262a. Although the first peri-connecting structure 260 is shown to include a plurality of first peri-connecting wirings 261b and 262b disposed on different metal levels, this is only for convenience of explanation, and the present disclosure is not limited thereto.

The first peri-connecting wirings 261b and 262b and the first peri-connecting vias 261a and 262a may each include a conductive material. Although the first peri-connecting wiring 261b and 262b and the first peri-connecting vias 261a and 262a are shown as being different films, the present disclosure is not limited thereto.

A first bonding pad BP1 may be disposed on the first peri-gate structure PG1. The first peri-connecting structure 260 may be disposed between the first peri-gate structure PG1 and the first bonding pad BP1. The first bonding pad BP1 may be connected to the first peri-connecting structure 260.

A first bonding pad plug 263 may be disposed between the first bonding pad BP1 and the first peri-connecting structure 260. The first bonding pad plug 263 may connect the first bonding pad BP1 and the first peri-connecting structure 260.

The first bonding pad BP1 and the first bonding pad plug 263 may be disposed in the first peri-interlayer insulating film 265. The first bonding pad plug 263 and the first bonding pad BP1 may each include a conductive material including a metal. Although the first bonding pad BP1 is shown as being a single film, this is only for convenience of explanation and the present disclosure is not limited thereto.

Shielding structures 171, SL and 175 may be disposed on the first substrate 100. For example, the shielding structures 171, SL and 175 may be disposed on the first bonding pad BP1. The shielding structures 171, SL and 175 may be spaced apart from the first bonding pad BP1 in the third direction DR3.

The shielding structures 171, SL and 175 may include a shielding conductive pattern SL and shielding insulation films 171 and 175. For example, the shielding insulation films 171 and 175 may include a shielding insulation liner 171 and a shielding insulation capping film 175.

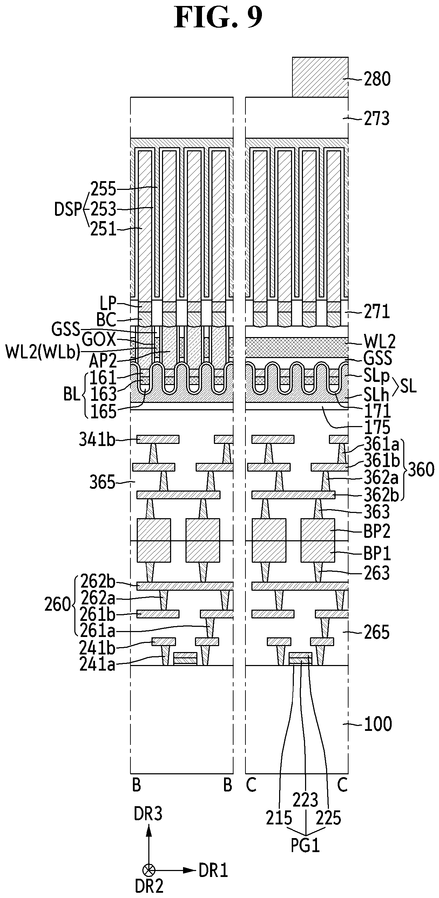

In the semiconductor device according to some embodiments, the shielding conductive pattern SL may include a plurality of shielding conductive line patterns (see SLp of FIG. 9) having a line shape. Each shielding conductive pattern SL may extend in the second direction DR2. The shielding conductive patterns SL may be adjacent to each other in the first direction DR1. For example, each of the first direction DR1 and the second direction DR2 may be a horizontal direction that is horizontal (i.e., parallel) to the upper surface of the first substrate 100. The first direction DR1 and the second direction DR2 may intersect each other.

Each shielding conductive pattern SL may extend from the cell array region CAR to the peripheral circuit region PCR. An end of each shielding conductive pattern SL may be disposed on the peripheral circuit region PCR.

The shielding conductive pattern SL includes a conductive material. The shielding conductive pattern SL may include, for example, at least one of a conductive metal nitride, a conductive metal silicon nitride, a metal carbonitride, a conductive metal silicide, a conductive metal oxide, a two-dimensional material, or a metal.

The shielding insulation capping film 175 may be disposed on the first bonding pad BP1. The shielding insulation capping film 175 may be disposed between the first bonding pad BP1 and the shielding conductive pattern SL. For example, the shielding insulation capping film 175 may be in contact with the shielding conductive pattern SL.

The shielding insulation capping film 175 may have a line shape extending in the second direction DR2 along the shielding conductive pattern SL. Unlike the shown example, the shielding insulation capping film 175 may have a flat plate shape. In other words, the shielding insulation capping film 175 may overlap the bit line BL in the third direction DR3. For example, the third direction DR3 may be a vertical direction that is perpendicular to the upper surface of the first substrate 100. The third direction DR3 may intersect the first direction DR1 and the second direction DR2.

The shielding insulation liner 171 may be disposed on the shielding conductive pattern SL. The shielding insulation liner 171 may extend along the profile of the shielding conductive pattern SL.

The shielding insulation liner 171 may be disposed between the bit line BL and the first bonding pad BP1. Unlike the shown example, from viewpoint of a cross-sectional view, the shielding insulation liners 171 formed along the profile of the shielding conductive pattern SL adjacent to each other in the first direction DR1 may be connected to each other.

The shielding insulation liner 171 and the shielding insulation capping film 175 may each be made up of an insulating material. When the shielding insulation liner 171 and the shielding insulation capping film 175 include the same material, the boundary between the shielding insulation liner 171 and the shielding insulation capping film 175 may not be distinguished.

Since the shielding structures 171, SL and 175 are disposed between the bit lines BL adjacent to each other in the first direction DR1, a coupling noise between the bit lines BL may be reduced.

The bit lines BL may be disposed on the first substrate 100. For example, the bit lines BL may be disposed on the first bonding pad BP1.

The bit lines BL may extend longitudinally in the second direction DR2. The adjacent bit lines BL may be spaced apart from each other in the first direction DR1. The bit lines BL include a long side wall extending in the second direction DR2, and a short side wall extending in the first direction DR1.

The bit line BL may be disposed adjacent to the shielding conductive pattern SL. The bit line BL may be disposed adjacent to the shielding conductive pattern SL in the first direction DR1. In other words, the shielding conductive pattern SL may extend in the second direction DR2 along the long side wall of the bit lines BL.

The bit line BL may be disposed between the shielding conductive patterns SL adjacent to each other in the first direction DR1. The bit line BL may be disposed on the shielding insulation liner 171. For example, the shielding insulation liner 171 may be in contact with the bit line BL.

Each bit line BL may extend from the cell array region CAR to the peripheral circuit region PCR. An end of each bit line BL may be disposed on the peripheral circuit region PCR.

The bit line BL may include an upper surface BL_US and a bottom surface that are opposite to each other in the third direction DR3. The upper surface BL_US of the bit line may front (i.e., face) a first active pattern AP1 and a second active pattern AP2 to be described later. In the semiconductor device according to some embodiments, the shielding conductive pattern SL may not be disposed on the bottom surface of the bit line BL.

Each bit line BL may include a semiconductor pattern 161, a metal pattern 163, and a bit line mask pattern 165 that are stacked sequentially. Unlike the shown example, as an example, the bit line BL may include one of the semiconductor pattern 161 or the metal pattern 163. As another example, the bit line BL may not include the bit line mask pattern 165.

The bit line BL may include a conductive bit line including a conductive material. The conductive bit line includes a film made of a conductive material in the bit line BL. The conductive bit line may include a semiconductor pattern 161 and a metal pattern 163.

The semiconductor pattern 161 may include a conductive semiconductor material. The conductive semiconductor material may be, for example, a semiconductor material doped with impurities. The semiconductor pattern 161 may include at least one of polysilicon, polysilicon germanium, poly germanium, amorphous silicon, amorphous silicon germanium, or amorphous germanium.

The metal pattern 163 may include a conductive material including a metal. The metal pattern 163 may include, for example, at least one of a conductive metal nitride, a conductive metal silicon nitride, a metal carbonitride, a conductive metal silicide, a conductive metal oxide, a two-dimensional material, or a metal.

The bit line mask pattern 165 may include an insulating material. The bit line mask pattern 165 may include, but is not limited to, a silicon nitride, a silicon oxynitride or the like.

The second peri-gate structure PG2 may be disposed on the peri-active pattern P_ACT. For example, the second peri-gate structure PG2 may be disposed on the first surface P_S1 of the peri-active pattern.

In the semiconductor device according to some embodiments, the first surface P_S1 of the peri-active pattern may face the first substrate 100. The second peri-gate structure PG2 may face the first peri-gate structure PG1.

The second peri-gate structure PG2 may be included in a sensing transistor, a transfer transistor, a drive transistor, and the like. Various peripheral circuit transistors may be needed for the semiconductor device to operate. In the semiconductor device according to some embodiments, some of the peripheral circuit transistors may be disposed on the first substrate 100, and the rest of the peripheral circuit transistors may be disposed on the peri-active pattern P_ACT. As the transistors of the peripheral circuit are dividedly disposed on the first substrate 100 and the peri-active pattern P_ACT, an area in which the peripheral circuit transistors are disposed may be reduced. The degree of integration and size of the semiconductor device can be reduced accordingly.

The second peri-gate structure PG2 may include a second peri-gate insulating film 315, a second peri-lower conductive pattern 323, a second peri-upper conductive pattern 325, and a second peri-gate mask pattern 326. The second peri-gate insulating film 315 may include a silicon oxide film, a silicon oxynitride film, a high dielectric constant insulating film having a higher dielectric constant than the silicon oxide film, or a combination thereof. The high dielectric constant insulating film may include, for example, but is not limited to, at least one of a metal oxide, a metal oxynitride, a metal silicon oxide, or a metal silicon oxynitride.

In the second peri-gate structure PG2, the second peri-lower conductive pattern 323, the second peri-upper conductive pattern 325, and the second peri-gate mask pattern 326 may be formed simultaneously with the bit line BL. The stacked structure of the second peri-gate structure PG2 except for the second peri-gate insulating film 315 may have the same stacked structure as the bit line BL. That is, the second peri-lower conductive pattern 323 includes the same material as the semiconductor pattern 161. The second peri-upper conductive pattern 325 includes the same material as the metal pattern 163. The second peri-gate mask pattern 326 includes the same material as the bit line mask pattern 165.

The second peri-gate structure PG2 may include a second peri-gate electrode including a conductive material. The second peri-gate electrode may include a second peri-lower conductive pattern 323 and a second peri-upper conductive pattern 325. A thickness T22 of the second peri-gate electrode in the second peri-gate structure PG2 may be the same as a thickness T11 of the conductive bit line in the bit line BL. For example, the thicknesses T11 and T22 may be taken in the third direction DR3.

Although not shown, a peri-etching stop film may extend along the profile of the second peri-gate structure PG2, the first surface P_S1 of the peri-active pattern, and the profile of the bit line BL. The peri-etching stop film may extend along one surface of the peri-field insulating film STI. The one surface of the peri-field insulating film STI may face the first substrate 100.

A second peri-interlayer insulating film 365 may be disposed on the first surface P_S1 of the peri-active pattern. The second peri-interlayer insulating film 365 may be disposed on one surface of the peri-field insulating film STI. The second peri-interlayer insulating film 365 may be disposed on the first bonding pad BP1. The second peri-interlayer insulating film 365 may be on (e.g., may cover) the bit line BL and the second peri-gate structure PG2. The second peri-interlayer insulating film 365 includes an insulating material.

A second peri-contact plug 341a and a second peri-wiring line 341b may be disposed in the second peri-interlayer insulating film 365. The second peri-contact plug 341a may be connected to a second source/drain region disposed on at least one side of the second peri-gate structure PG2. Although not shown, the second peri-contact plug 341a may be connected to the second peri-gate electrodes 323 and 325 of the second peri-gate structure PG2. The second peri-contact plug 341a may be connected to the conductive bit lines 161 and 163 of the bit line BL. Although not shown, the second peri-contact plug 341a may be connected to a first word line WL1 and a second word line WL2.

The second peri-wiring line 341b may be disposed on the second peri-contact plug 341a. The second peri-wiring line 341b is connected to the second peri-contact plug 341a. For example, the second peri-wiring line 341b may be a wiring line that is closest to the second peri-gate structure PG2 in the third direction DR3. The second peri-contact plug 341a and the second peri-wiring line 341b each include a conductive material.

A second peri-connecting structure 360 may be disposed on the second peri-gate structure PG2. In the semiconductor device according to some embodiments, the second peri-connecting structure 360 may be disposed on the first surface P_S1 of the peri-active pattern.

The second peri-connecting structure 360 may be disposed on the second peri-wiring line 341b. The second peri-connecting structure 360 may be connected to the second peri-wiring line 341b. The second peri-connecting structure 360 may be connected to the second peri-gate structure PG2. The second peri-connecting structure 360 may be disposed in the second peri-interlayer insulating film 365.

The second peri-connecting structure 360 may include second peri-connecting wirings 361b and 362b, second peri-connecting vias 361a and 362a, and a first peri-through via 362c. Although the second peri-connecting structure 360 is shown as including a plurality of second peri-connecting wirings 361b and 362b disposed at different metal levels from each other, this is only for convenience of explanation, and the present disclosure is not limited thereto. The first peri-through via 362c may be connected to one of the second peri-connecting wirings 361b and 362b. The first peri-through via 362c may penetrate (i.e., extend into) the peri-field insulating film STI. The first peri-through via 362c may extend to the height level of the second surface P_S2 of the peri-active pattern.

The second peri-connecting wirings 361b and 362b, the second peri-connecting vias 361a and 362a, and the first peri-through via 362c may each include a conductive material.

A second bonding pad BP2 may be disposed on the second peri-gate structure PG2. The second bonding pad BP2 may be disposed on the first surface P_S1 of the peri-active pattern. The second peri-connecting structure 360 may be disposed between the second peri-gate structure PG2 and the second bonding pad BP2. The second bonding pad BP2 may be connected to the second peri-connecting structure 360.

The second bonding pad BP2 may be connected to the first bonding pad BP1. The first bonding pad BP1 and the second bonding pad BP2 may be disposed between the first peri-gate structure PG1 and the second peri-gate structure PG2.

A second bonding pad plug 363 may be disposed between the second bonding pad BP2 and the second peri-connecting structure 360. The second bonding pad plug 363 may connect the second bonding pad BP2 and the second peri-connecting structure 360.

The second bonding pad BP2 and the second bonding pad plug 363 may be disposed in a second peri-interlayer insulating film 365. The second bonding pad plug 363 and the second bonding pad BP2 may each include a conductive material including a metal.

The first active patterns AP1 and the second active patterns AP2 may be disposed on each bit line BL. The first active patterns AP1 and the second active patterns AP2 may be alternately disposed along the second direction DR2. The first active pattern AP1 and the second active pattern AP2 are spaced apart from the first substrate 100 in the third direction DR3.

The first active patterns AP1 may be spaced apart from each other in the first direction DR1. The first active patterns AP1 may be spaced apart at regular intervals. The second active patterns AP2 may be spaced apart from each other in the first direction DR1. The second active patterns AP2 may be spaced apart at regular intervals. The first active pattern AP1 may be spaced apart from the second active pattern AP2 in the second direction DR2. The first active patterns AP1 and the second active patterns AP2 may be two-dimensionally arranged along the first direction DR1 and the second direction DR2 that intersect each other.

In FIG. 2, the first active pattern AP1 and the second active pattern AP2 may be spaced apart from the peri-active pattern P_ACT in the second direction DR2. Although not shown, the first active pattern AP1 and the second active pattern AP2 may be spaced apart from the peri-active pattern P_ACT in the first direction DR1.

For example, the first active pattern AP1 and the second active pattern AP2 may each be made of a single crystal semiconductor material. As an example, the first active pattern AP1 and the second active pattern AP2 may each be made of single crystal silicon.

Each of the first active pattern AP1 and the second active pattern AP2 may have a length in the first direction DR1, a width in the second direction DR2, and a height in the third direction DR3. Each of the first active pattern AP1 and the second active pattern AP2 may have a substantially uniform width. That is, each of the first active pattern AP1 and the second active pattern AP2 may have substantially the same width in the first and second surfaces S1 and S2. Also, the width of the first active pattern AP1 may be equal to the width of the second active pattern AP2.

The width of the first active pattern AP1 and the width of the second active pattern AP2 in the second direction DR2 may be several nanometers (nm) to several tens of nm. For example, the width of the first active pattern AP1 and the width of the second active pattern AP2 may be in a range of, but are not limited to, 1 nm to 30 nm, more preferably, 1 nm to 10 nm. The lengths of each of the first active pattern AP1 and the second active pattern AP2 may be greater than a line width of the bit line BL. That is, the lengths of each of the first active pattern AP1 and the second active pattern AP2 in the first direction DR1 may be greater than the width of the bit line BL in the first direction DR1.

In FIG. 5, each of the first active pattern AP1 and the second active pattern AP2 includes a first surface S1 and a second surface S2 that are opposite to each other in the third direction DR3. For example, the first surfaces S1 of the first active pattern AP1 and the second active pattern AP2 may face the bit line BL. In the semiconductor device according to some embodiments, the first surfaces S1 of the first active pattern AP1 and the second active pattern AP2 may face the first substrate 100. The second surfaces S2 of the first active pattern AP1 and the second active pattern AP2 may face a contact pattern BC.

The first surfaces S1 of the first active pattern AP1 and the second active pattern AP2 are connected to the bit line BL. For example, the first surfaces S1 of the first active pattern AP1 and the second active pattern AP2 may be connected to the semiconductor pattern 161 of the bit line BL. Unlike the shown example, if the semiconductor pattern 161 is omitted, the first surfaces S1 of the first active pattern AP1 and the second active pattern AP2 may be connected to the metal pattern 163. The second surfaces S2 of the first active pattern AP1 and the second active pattern AP2 may be connected to the contact pattern BC.

Each of the first active pattern AP1 and the second active pattern AP2 may include a first side wall SS1 and a second side wall SS2 that are opposite to each other in the second direction DR2. The first side wall SS1 of the first active pattern AP1 may face the second side wall SS2 of the second active pattern AP2.

The second side wall SS2 of the first active pattern AP1 may be adjacent to the first word line WL1. The first side wall SS1 of the second active pattern AP2 may be adjacent to the second word line WL2.

Although not shown, as an example, each of the first active pattern AP1 and the second active pattern AP2 may include a first dopant region adjacent to the bit line BL, and a second dopant region adjacent to the contact pattern BC. Each of the first active pattern AP1 and the second active pattern AP2 may include a channel region between the first dopant region and the second dopant region. The first dopant region and the second dopant region are regions in which dopants are doped in the first active pattern AP1 and the second active pattern AP2. Unlike the above example, each of the first active pattern AP1 and the second active pattern AP2 may not include at least one of the first dopant region and the second dopant region.

At the time of operation of the semiconductor device, the channel region of the first active pattern AP1 and the second active pattern AP2 may be controlled by the first and second word lines WL1 and WL2 and the back gate electrode BG. Because the first active pattern AP1 and the second active pattern AP2 are made of a single crystal semiconductor material, the leakage current characteristics of the semiconductor device can be improved.

The back gate electrodes BG may be disposed on the bit line BL and the shielding conductive pattern SL. The back gate electrodes BG may be spaced apart from each other in the second direction DR2. The back gate electrodes BG may be spaced apart at regular intervals. Each back gate electrode BG may extend in the first direction DR1 across the bit line BL.

Each back gate electrode BG may be disposed between the first active pattern AP1 and the second active pattern AP2 adjacent to each other in the second direction DR2. That is, the first active pattern AP1 may be disposed on one side of each back gate electrode BG, and the second active pattern AP2 may be disposed on the other side of each back gate electrode BG. The height of the back gate electrode BG in the third direction DR3 may be smaller than the heights of the first active pattern AP1 and the second active pattern AP2.

Each back gate electrode BG may be disposed between the first side wall SS1 of the first active pattern AP1 and the second side wall SS2 of the second active pattern AP2. Each back gate electrode BG may be disposed on the first side wall SS1 of the first active pattern AP1 and the second side wall SS2 of the second active pattern AP2.

The first active pattern AP1 may be disposed between the first word line WL1 and the back gate electrode BG. The second active pattern AP2 may be disposed between the second word line WL2 and the back gate electrode BG. A pair of first word line WL1 and second word line WL2 may be disposed between the back gate electrodes BG adjacent to each other in the second direction DR2.

The back gate electrode BG may include a first surface BG_S1 and a second surface BG_S2 opposite to each other in the third direction DR3. The first surface BG_S1 of the back gate electrode is closer to the bit line BL than the second surface BG_S2 of the back gate electrode. The first surface BG_S1 of the back gate electrode may face the bit line BL.

The back gate electrode BG includes a conductive material, and may include, for example, at least one of a conductive semiconductor material, a conductive metal nitride, a conductive metal silicon nitride, a metal carbonitride, a conductive metal silicide, a conductive metal oxide, a two-dimensional material, or a metal.

When the semiconductor device operates, a voltage may be applied to the back gate electrode BG to adjust the threshold voltage of the vertical channel transistor. Because the threshold voltage of the vertical channel transistor is adjusted, the leakage current characteristic may be prevented from being degraded.

A back gate isolation pattern 111 may be disposed between the first active pattern AP1 and the second active pattern AP2 that are adjacent to each other in the second direction DR2. The back gate isolation pattern 111 may extend in the first direction DR1 in parallel with the back gate electrode BG. The back gate isolation pattern 111 may be disposed on the second surface BG_S2 of the back gate electrode.

The back gate isolation pattern 111 may be made of an insulating material. The back gate isolation pattern 111 may include, but is not limited to, a silicon oxide film, a silicon oxynitride film or a silicon nitride film.

A back gate insulation pattern 113 may be disposed between the back gate electrode BG and the first active pattern AP1, and between the back gate electrode BG and the second active pattern AP2. The back gate insulation pattern 113 may be disposed between the back gate isolation pattern 111 and the first active pattern AP1, and between the back gate isolation pattern 111 and the second active pattern AP2.

The back gate insulation pattern 113 may be made of an insulating material. The back gate insulation pattern 113 may include, for example, a silicon oxide film, a silicon oxynitride film, a high dielectric constant insulating film having a higher dielectric constant than the silicon oxide film, or a combination thereof.

A back gate capping pattern 115 may be disposed between the bit line BL and the back gate electrode BG. The back gate capping pattern 115 may be disposed between the first active pattern AP1 and the second active pattern AP2 that are adjacent to each other in the second direction DR2. The back gate capping pattern 115 may extend in the first direction DR1 parallel to the bit line BL and the back gate electrode BG. The back gate capping pattern 115 and the bit line BL may be disposed on the first surface BG_S1 of the back gate electrode.

The back gate capping pattern 115 may be made of an insulating material. The back gate capping pattern 115 may include, but is not limited to, at least one of a silicon oxide film, a silicon oxynitride film, or a silicon nitride film.

The first word line WL1 and the second word line WL2 are disposed on the bit line BL and the shielding conductive pattern SL. Each of the first word line WL1 and the second word line WL2 may extend in the first direction DR1. The first word line WL1 and the second word line WL2 may be arranged alternately in the second direction DR2.

The first word line WL1 may be disposed on the second side walls SS2 of the first active patterns AP1. The second word line WL2 may be disposed on the first side walls SS1 of the second active patterns AP2. The first active patterns AP1 and the second active patterns AP2 may be disposed between the first word line WL1 and the second word line WL2 that are adjacent to each other in the second direction DR2.

The first word line WL1 and the second word line WL2 may be spaced apart from the bit line BL and the contact pattern BC in the third direction DR3. The first word line WL1 and the second word line WL2 may be located between the bit line BL and the contact pattern BC.

Each of the first word line WL1 and the second word line WL2 may have a width in the second direction DR2. The width of the first word line WL1 and the width of the second word line WL2 on the bit line BL may be different from the width of the first word line WL1 and the width of the second word line WL2 on the shielding conductive line SL.

For example, each of the first word line WL1 and the second word line WL2 may include a first portion WLa of the word line, and a second portion WLb of the word line. A width of the first portion WLa of the word line in the second direction DR2 may be smaller than a width of the second portion WLb of the word line in the second direction DR2. As an example, the first portion WLa of the word line may be disposed on the bit line BL. The second portion WLb of the word line may be disposed on the shielding conductive pattern SL.

Each of the first word line WL1 and the second word line WL2 may include a first portion WLa of the word line and a second portion WLb of the word line that are alternately disposed along the first direction DR1. In the first word line WL1, each of the first active patterns AP1 may be disposed between the second portions WLb of the word lines adjacent to each other in the first direction DR1. In the second word line WL2, each of the second active patterns AP2 may be disposed between the second portions WLb of the word lines adjacent to each other in the first direction DR1.

Unlike the shown example, the width of the first portion WLa of the word line in the second direction DR2 may be equal to the width of the second portion WLb of the word line in the second direction DR2.

The first word line WL1 and the second word line WL2 may include a first surface WL_S1 and a second surface WL_S2 that are opposite to each other in the third direction DR3. The first surface WL_S1 of the first and second word lines is closer to the bit line BL than the second surface WL_S2 of the first and second word lines. The first surface WL_S1 of the first and second word lines faces the bit line BL.

The first word line WL1 will be explained as an example. As an example, a height of the first word line WL1 in the third direction DR3 may be equal to a height of the back gate electrode BG in the third direction DR3. As another example, the height of the first word line WL1 in the third direction DR3 may be greater than the height of the back gate electrode BG in the third direction DR3. As yet another example, the height of the first word line WL1 in the third direction DR3 may be smaller than the height of the back gate electrode BG in the third direction DR3.

Also, as an example, the height of the first surface WL_S1 of the first word line may be equal to the height of the first surface BG_S1 of the back gate electrode, on the basis of the upper surface BL_US of the bit line. As another example, the first surface WL_S1 of the first word line may be higher than the first surface BG_S1 of the back gate electrode. As yet another example, the first surface WL_S1 of the first word line may be lower than the first surface BG_S1 of the back gate electrode.

In addition, as an example, the height of the second surface WL_S2 of the first word line may be equal to the height of the second surface BG_S2 of the back gate electrode, on the basis of the upper surface BL_US of the bit line. As another example, the second surface WL_S2 of the first word line may be higher than the second surface BG_S2 of the back gate electrode. As yet another example, the second surface WL_S2 of the first word line may be lower than the second surface BG_S2 of the back gate electrode.

The first surfaces WL_S1 of the first and second word lines WL1 and WL2 may be a plane (i.e., may be planar). Unlike the shown example, as an example, the first surfaces WL_S1 of the first and second word lines WL1 and WL2 may be concavely rounded. As another example, each of the first word line WL1 and the second word line WL2 may have the form of a spacer. In other words, the first surfaces WL_S1 of the first and second word lines WL1 and WL2 may be convexly rounded.

The second surface WL_S2 of the first and second word lines WL1 and WL2 may be a plane (i.e., may be planar). Unlike the shown example, the second surfaces WL_S2 of the first and second word lines WL1 and WL2 may have a concave curved surface. The first surface BG_S1 of the back gate electrode and the second surface BG_S2 of the back gate electrode are shown as being a plane (i.e., as being planar), but the present disclosure is not limited thereto.

Gate insulation patterns GOX may be disposed between the first word line WL1 and the first active pattern AP1, and between the second word line WL2 and the second active pattern AP2. The gate insulation pattern GOX may extend in the first direction DR1 in parallel with the first word line WL1 and the second word line WL2.

The gate insulation pattern GOX may include a silicon oxide film, a silicon oxynitride film, a high dielectric constant insulating film having a higher dielectric constant than the silicon oxide film, or a combination thereof. The high dielectric constant insulating film may include, for example, but is not limited to, at least one of a metal oxide, a metal oxynitride, a metal silicon oxide, or a metal silicon oxynitride.

The gate insulation pattern GOX may extend along the second side wall SS2 of the first active pattern AP1, and may extend along the first side wall SS1 of the second active pattern AP2. In the semiconductor device according to some embodiments, from viewpoint of a cross-sectional view, the gate insulation pattern GOX between the first active pattern AP1 and the first word line WL1 may be separated from the gate insulation pattern GOX between the second active pattern AP2 and the second word line WL2.

The gate isolation pattern GSS may be disposed on the bit line BL. The gate isolation pattern GSS may be disposed between the first word line WL1 and the second word line WL2 that are adjacent to each other in the second direction DR2. The first word line WL1 and the second word line WL2 may be separated by the gate isolation pattern GSS. The gate isolation pattern GSS may extend in the first direction DR1 between the first word line WL1 and the second word line WL2.

The first word line WL1 may be disposed between the gate isolation pattern GSS and the first active pattern AP1. The second word line WL2 may be disposed between the gate isolation pattern GSS and the second active pattern AP2.

The gate isolation pattern GSS may be made of an insulating material. Although the gate isolation pattern GSS is shown as being a single film, this is only for convenience of explanation, and the present disclosure is not limited thereto.

The first interlayer insulating film 271 may be disposed on the peri-active pattern P_ACT and the peri-field insulating film STI. The first interlayer insulating film 271 may be disposed on the second surface P_S2 of the peri-active pattern. The first interlayer insulating film 271 includes an insulating material. Although the first interlayer insulating film 271 is shown as being a single film, this is only for convenience of explanation, and the present disclosure is not limited thereto.

The contact patterns BC may be disposed in the first interlayer insulating film 271. The contact patterns BC may be connected to each of the first active pattern AP1 and the second active pattern AP2. The contact patterns BC may be connected to the second surfaces S2 of the first active pattern AP1 and the second active pattern AP2. Each contact pattern BC may have various shapes, such as a circular shape, an elliptical shape, a rectangular shape, a square shape, a rhombic shape, and a hexagonal shape from a planar viewpoint.

The contact pattern BC may include a conductive material. The contact pattern BC may include at least one of, for example, doped polysilicon, a conductive metal nitride, a conductive metal silicon nitride, a metal carbonitride, a conductive metal silicide, a conductive metal oxide, a two-dimensional material, or a metal.

Landing pads LP may be disposed on the contact pattern BC. The landing pads LP may be disposed in the first interlayer insulating film 271. From a planar viewpoint, the landing pads LP may have various shapes, such as a circular shape, an elliptical shape, a rectangular shape, a square shape, a rhombic shape, and a hexagonal shape.

The landing pads LP may include a conductive material, and may include, for example, at least one of doped polysilicon, a conductive metal nitride, a conductive metal silicon nitride, a metal carbonitride, a conductive metal silicide, a conductive metal oxide, a two-dimensional material, or a metal.

A connecting buffer conductive pattern 285 may be disposed in the first interlayer insulating film 271. The connecting buffer conductive pattern 285 may be disposed on the second surface P_S2 of the peri-active pattern. For example, the connecting buffer conductive pattern 285 may be disposed on the peri-field insulating film STI.

The connecting buffer conductive pattern 285 may be connected to the second peri-connecting structure 360. In the semiconductor device according to some embodiments, the connecting buffer conductive pattern 285 may be directly connected to the second peri-connecting structure 360. For example, the connecting buffer conductive pattern 285 may be in contact with the second peri-connecting structure 360.

For example, the connecting buffer conductive pattern 285 may be connected to the first peri-through via 362c. The connecting buffer conductive pattern 285 may be in contact with the first peri-through via 362c. The connecting buffer conductive pattern 285 may include a first connecting buffer pattern 286 and a second connecting buffer pattern 287. For example, the first connecting buffer pattern 286 may be in contact with the first peri-through via 362c.

The first connecting buffer pattern 286 may include, but is not limited to, the same material as the contact pattern BC. The second connecting buffer pattern 287 may include, but is not limited to, the same material as the landing pad LP.

The data storage patterns DSP may be disposed on each of the landing pads LP. The data storage patterns DSP may be electrically connected to each of the first and second active patterns AP1 and AP2. The data storage patterns DSP may be arranged in the form a matrix along the first direction DR1 and the second direction DR2, as shown in FIG. 2. The data storage patterns DSP may completely or partially overlap the landing pads LP in the third direction DR3. The data storage patterns DSP may be in contact with all or a part of the upper surface of the landing pads LP.

As an example, the data storage patterns DSP may be a capacitor. The data storage patterns DSP may include a capacitor dielectric film 253 interposed between a storage electrode 251 and a plate electrode 255. For example, the storage electrode 251 may be in contact with the landing pad LP. From a planar viewpoint, the storage electrode 251 may have various shapes, such as a circular shape, an elliptical shape, a rectangular shape, a square shape, a rhombic shape, and a hexagonal shape. The data storage patterns DSP may be in contact with all or a part of the upper surfaces of the landing pads LP.

The storage electrode 251 and the plate electrode 255 may each include, for example, at least one of a conductive semiconductor material, a conductive metal nitride, a conductive metal silicon nitride, a metal carbonitride, a conductive metal silicide, a conductive metal oxide, or a metal. The capacitor dielectric film 253 may include at least one of a ferroelectric material, an antiferroelectric material, or a paraelectric material. For example, the capacitor dielectric film 253 may include one of the ferroelectric material, the antiferroelectric material, the paraelectric material, combinations of the ferroelectric material and antiferroelectric material, combinations of the ferroelectric material and paraelectric material, combinations of paraelectric material and antiferroelectric material, and/or combinations of the ferroelectric material, the antiferroelectric material and the paraelectric material.

In other embodiments, the data storage patterns DSP may be variable resistance patterns that may be switched between two resistance states by electrical pulses applied to the memory element. For example, the data storage patterns DSP may include a phase-change material, perovskite compounds, transition metal oxide, magnetic materials, ferromagnetic materials or antiferromagnetic materials.

The second interlayer insulating film 272 may be disposed on the first interlayer insulating film 271. The second interlayer insulating film 272 may be on (e.g., may cover) the side walls of the data storage pattern DSP. The second interlayer insulating film 272 includes an insulating material.

A third interlayer insulating film 273 may be disposed on the second interlayer insulating film 272 and the data storage pattern DSP. The third interlayer insulating film 273 includes an insulating material.

A connecting pad 280 may be disposed on the third interlayer insulating film 273. The connecting pad 280 may be disposed on the second surface P_S2 of the peri-active pattern.

The connecting pad 280 may be connected to the data storage pattern DSP. The connecting pad 280 may be connected to the second peri-connecting structure 360.

A connecting pad connection plug 281 may be disposed in the second interlayer insulating film 272 and the third interlayer insulating film 273. The connecting pad connection plug 281 may connect the connecting pad 280 and the connecting buffer conductive pattern 285. The connecting pad connection plug 281 may be in contact with the connecting buffer conductive pattern 285.

A connecting pad plug 282 may be disposed in the third interlayer insulating film 273. The connecting pad plug 282 may connect the plate electrode 255 of the data storage pattern DSP and the connecting pad 280.

The connecting pad 280, the connecting pad connection plug 281, and the connecting pad plug 282 may each include at least one of a conductive metal nitride, a conductive metal silicon nitride, a metal carbonitride, a conductive metal oxide, or a metal.

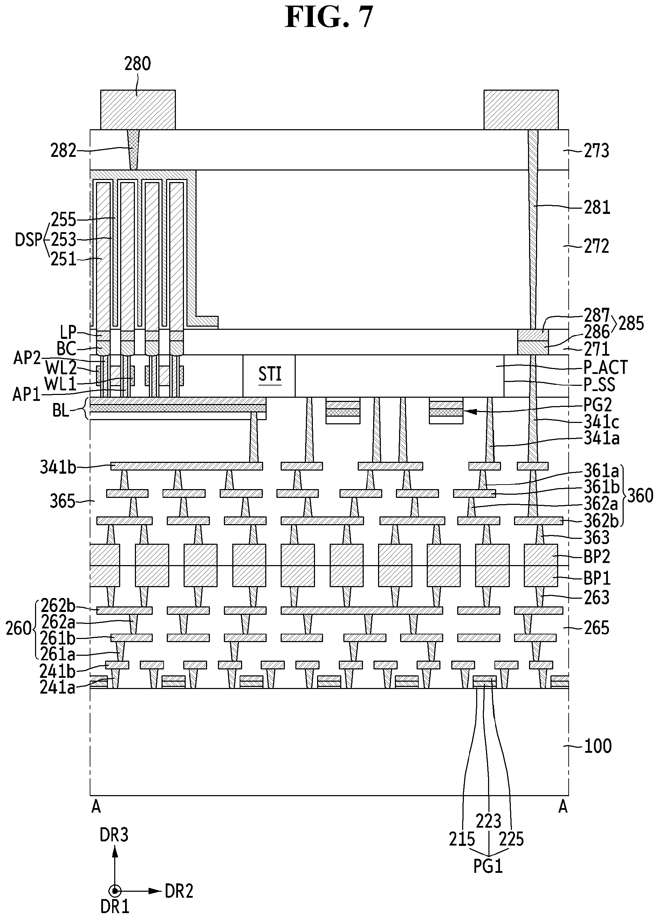

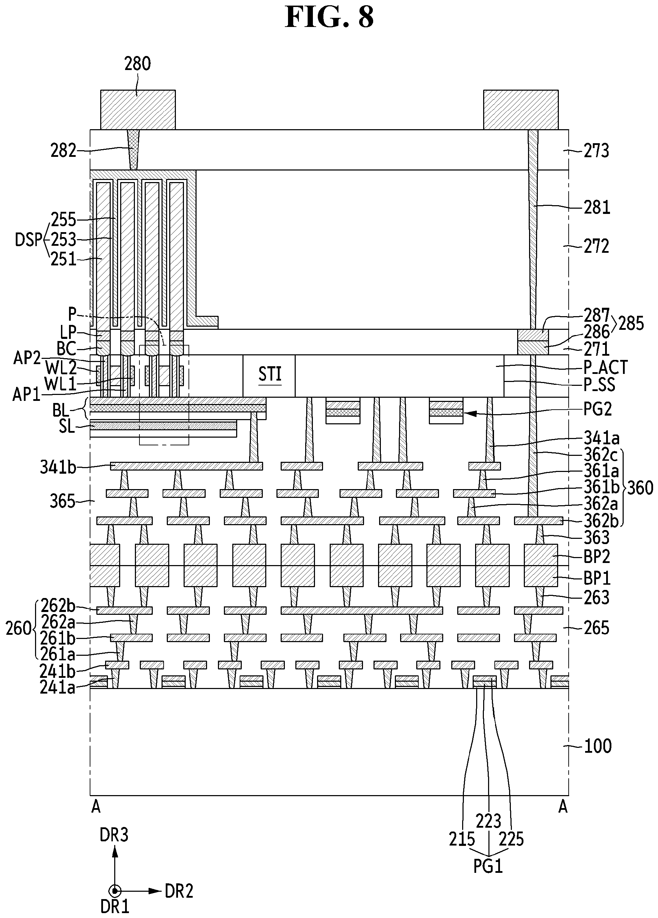

FIG. 7 is a diagram for explaining a semiconductor device according to some embodiments. FIGS. 8 to 10 are diagrams for explaining a semiconductor device according to some embodiments. For convenience of explanation, differences from those explained using FIGS. 1 to 6 will be mainly explained.

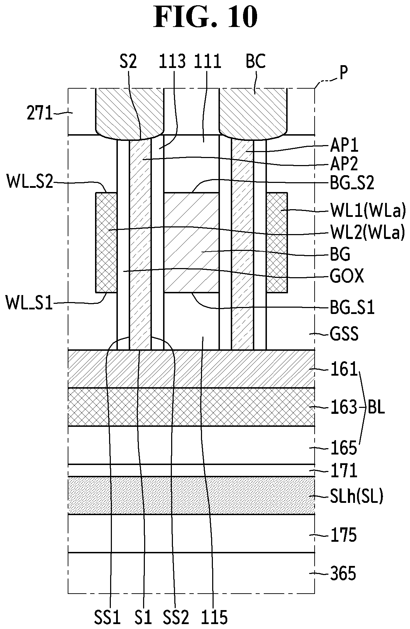

For reference, FIGS. 7 and 8 are cross-sectional views taken along line A-A of FIG. 2. FIG. 9 is a cross-sectional view taken along lines B-B and C-C of FIG. 2. FIG. 10 is an enlarged view of a portion P of FIG. 8.

Referring to FIG. 7, the semiconductor device according to some embodiments may further include a second peri-field through plug 341c.

The second peri-field through plug 341c may be connected to the second peri-wiring line 341b. The second peri-field through plug 341c may penetrate the peri-field insulating film STI. The second peri-field through plug 341c may extend to the height level of the second surface P_S2 of the peri-active pattern (e.g., see FIG. 6).

The second peri-field through plug 341c may be connected to the connecting buffer conductive pattern 285. The second peri-field through plug 341c may be in contact with the connecting buffer conductive pattern 285.

The second peri-connecting structure 360 may be connected to the second peri-field through plug 341c. The second peri-connecting structure 360 may be connected to the connecting buffer conductive pattern 285 through the second peri-field through plug 341c.

Referring to FIGS. 8 to 10, in the semiconductor device according to some embodiments, the shielding conductive pattern SL may include a shielding conductive plate SLh and a plurality of shielding conductive line patterns SLp.

The shielding conductive plate SLh may have a flat plate shape. The shielding conductive line pattern SLp may protrude from the shielding conductive plate SLh in the third direction DR3. The shielding conductive line pattern SLp is directly connected to the shielding conductive plate SLh.

The shielding insulation liner 171 may extend along the profiles of the shielding conductive plate SLh and the shielding conductive line pattern SLp.

The shielding insulation capping film 175 may be disposed between the shielding conductive plate SLh and the first substrate 100. The shielding insulation capping film 175 may be in contact with the shielding conductive plate SLh.

The bit line BL may be disposed on the shielding conductive pattern SL. The bit line BL may be disposed on the shielding conductive plate SLh. The shielding conductive pattern SL may be disposed on a bottom surface of the bit line BL. For example, the shielding conductive plate SLh may be disposed on the bottom surface of the bit line BL.

The bit line BL may be disposed adjacent to the shielding conductive line pattern SLp. The bit line BL may be disposed adjacent to the shielding conductive line pattern SLp in the first direction DR1. The shielding conductive line pattern SLp may extend in the second direction DR2 along the long side wall of the bit line BL. The bit line BL may be disposed between the shielding conductive line patterns SLp adjacent to each other in the first direction DR1.

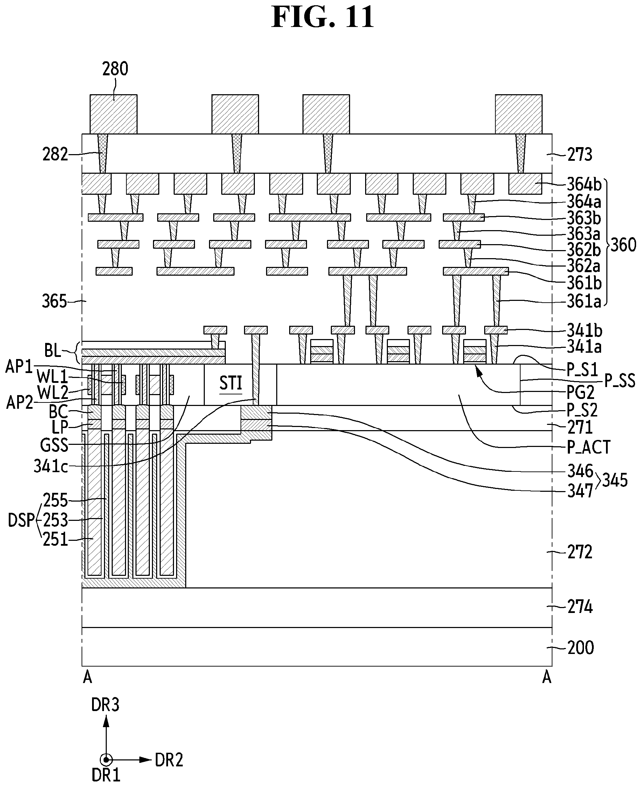

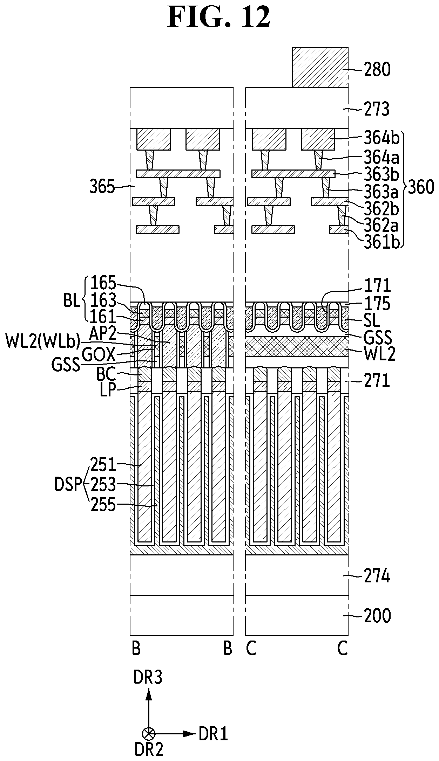

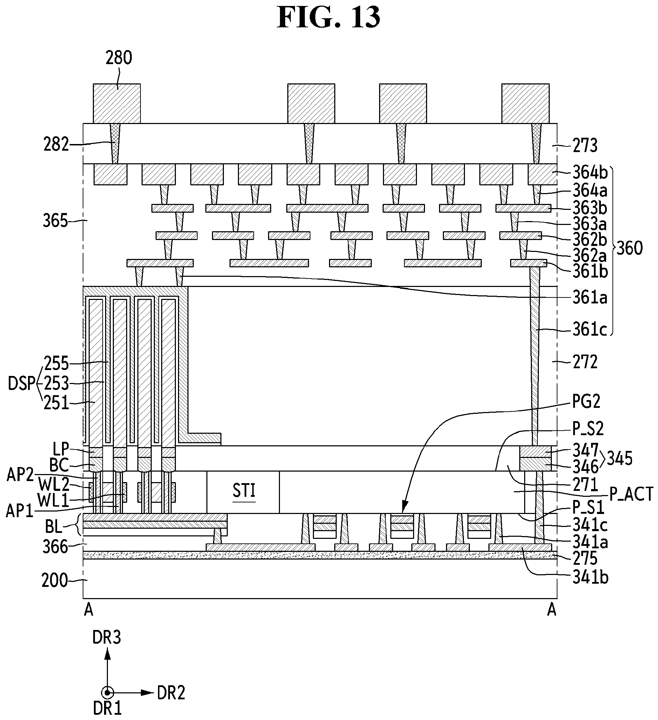

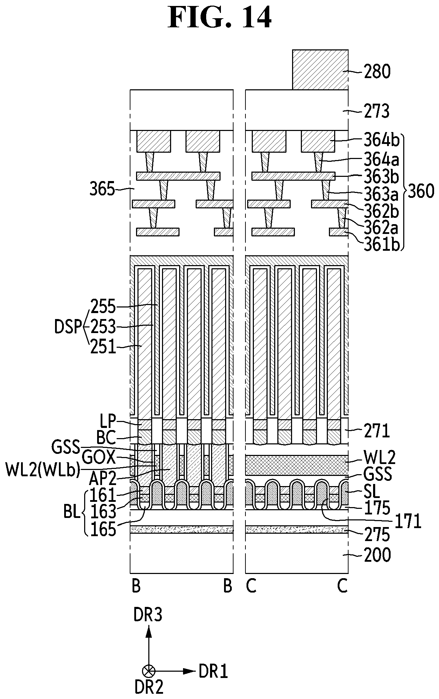

FIGS. 11 and 12 are diagrams for explaining a semiconductor device according to some embodiments. FIGS. 13 and 14 are diagrams for explaining a semiconductor device according to some embodiments. For convenience of explanation, differences from those explained using FIGS. 1 to 10 will be mainly explained.

Referring to FIGS. 11 to 14, in the semiconductor device according to some embodiments, a first channel pattern AP1, a second channel pattern AP2, and a peri-active pattern P_ACT may be formed on the second substrate 200.

The second substrate 200 may include a cell array region CAR in which a data storage pattern DSP is disposed, and a peripheral circuit region PCR defined around the cell array region CAR (e.g., see FIGS. 1 and 2). The peri-active pattern P_ACT may be disposed on the peripheral circuit region PCR of the second substrate 200.

The second substrate 200 may be a silicon substrate, or may include other materials, for example, but not limited to, silicon germanium, indium antimonide, lead telluride, indium arsenide, indium phosphide, gallium arsenide or gallium antimonide.

The first peri-gate structure (see PG1 of FIG. 3) is not disposed on the second substrate 200. Various peripheral circuit transistors may be disposed on the peri-active pattern P_ACT so that the semiconductor device operates.

The semiconductor device according to some embodiments may not include the first peri-gate structure (see PG1 of FIG. 3) and the first peri-connecting structure (see 260 of FIG. 3). In addition, the semiconductor device according to some embodiments may not include the first bonding pad BP1 and the second bonding pad BP2 (see FIGS. 3 and 4).

The connecting buffer conductive pattern 345 may be disposed in the first interlayer insulating film 271. The connecting buffer conductive pattern 345 may be disposed on the second surface P_S2 of the peri-active pattern. For example, the connecting buffer conductive pattern 345 may be disposed on the peri-field insulating film STI.

The connecting buffer conductive pattern 345 may include a first connecting buffer pattern 346 and a second connecting buffer pattern 347. The first connecting buffer pattern 346 may include, but is not limited to, the same material as the contact pattern BC. The second connecting buffer pattern 347 may include, but is not limited to, the same material as the landing pad LP.

The second peri-field through plug 341c may be connected to the connecting buffer conductive pattern 345. The second peri-field through plug 341c may be in contact with the connecting buffer conductive pattern 345.

In FIG. 11 and FIG. 12, the first surface P_S1 of the peri-active pattern does not face the second substrate 200. The second surface P_S2 of the peri-active pattern may face the second substrate 200. The second peri-gate structure PG2 does not face the second substrate 200.

The first surfaces (see S1 of FIG. 5) of the first active pattern AP1 and the second active pattern AP2 do not face the second substrate 200. The second surfaces (see S2 of FIG. 5) of the first active pattern AP1 and the second active pattern AP2 may face the second substrate 200.

The data storage pattern DSP may be disposed between the first active pattern AP1 and the second substrate 200, and between the second active pattern AP2 and the second substrate 200. A fourth interlayer insulating film 274 may be disposed between the data storage pattern DSP and the second substrate 200. The fourth interlayer insulating film 274 includes an insulating material.

The connecting buffer conductive pattern 345 may be connected to the data storage pattern DSP. For example, the connecting buffer conductive pattern 345 may be connected to the plate electrode 255 of the data storage pattern DSP. The second peri-field through plug 341c may be connected to the data storage pattern DSP.

The second peri-connecting structure 360 may be disposed on the first surface P_S1 of the peri-active pattern. The second peri-connecting structure 360 may be connected to the second peri-wiring line 341b. The second peri-connecting structure 360 may include second peri-connecting wirings 361b, 362b, 363b, and 364b and second peri-connecting vias 361a, 362a, 363a, and 364a.

The connecting pad 280 may be disposed on the first surface P_S1 of the peri-active pattern. The connecting pad 280 may be connected to the second peri-connecting structure 360. The connecting pad plug 282 may connect the connecting pad 280 and the second peri-connecting structure 360.

In FIGS. 13 and 14, the first surface P_S1 of the peri-active pattern may face the second substrate 200. The second peri-gate structure PG2 may face the second substrate 200. The second peri-gate structure PG2 may be disposed between the peri-active pattern P_ACT and the second substrate 200.

The second peri-contact plug 341a and the second peri-wiring line 341b may be disposed in the lower peri-interlayer insulating film 366. The lower peri-interlayer insulating film 366 may be disposed between the peri-active pattern P_ACT and the second substrate 200. The lower peri-interlayer insulating film 366 includes an insulating material.

The bonding insulating film 275 may be disposed on the second substrate 200. The bonding insulating film 275 may be disposed between the second substrate 200 and the lower peri-interlayer insulating film 366. The bonding insulating film 275 may include, but is not limited to, silicon carbonitride (SiCN). The second peri-wiring line 341b may be disposed on the bonding insulating film 275.

Unlike the shown example, the bonding insulating film 275 may not be disposed on the second substrate 200.

In some embodiments, the bonding insulating film 275 may be disposed between the first and second interlayer insulating films 265 and 365 in FIG. 3. In such a case, the bonding insulating film 275 may be disposed along the boundary between the first and second bonding pads BP1 and BP2.

The second peri-connecting structure 360 may be disposed on the second surface P_S2 of the peri-active pattern. The second peri-connecting structure 360 may be disposed on the data storage pattern DSP.

The second peri-connecting structure 360 may include second peri-connecting wirings 361b, 362b, 363b, and 364b, second peri-connecting vias 361a, 362a, 363a, and 364a, and a second peri-through via 361c. The second peri-through via 361c may be disposed in the second peri-interlayer insulating film 365 and the second interlayer insulating film 272.

The second peri-connecting structure 360 may be connected to the data storage pattern DSP. The second peri-connecting structure 360 may be connected to the second peri-field through plug 341c.

The second peri-connecting structure 360 may be connected to the connecting buffer conductive pattern 345. For example, the second peri-through via 361c may be connected to the connecting buffer conductive pattern 345. The second peri-through via 361c may be connected to the second peri-field through plug 341c.

The connecting pad 280 may be disposed on the second surface P_S2 of the peri-active pattern. The connecting pad 280 may be connected to the second peri-connecting structure 360.

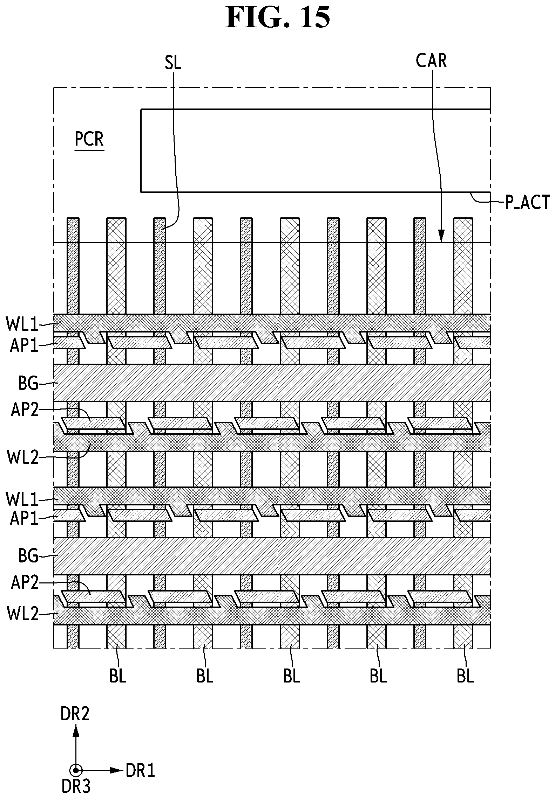

FIGS. 15 to 18 are diagrams for explaining a semiconductor device according to some embodiments, respectively. For convenience of explanation, differences from those explained using FIGS. 1 to 14 will be mainly explained.

Referring to FIG. 15, in the semiconductor device according to some embodiments, the first active pattern AP1 and the second active pattern AP2 may be alternately arranged in a diagonal direction with respect to the first direction DR1 and the second direction DR2. Here, the diagonal direction may be parallel to the upper surface of the first substrate (see 100 of FIG. 3).

From a planar viewpoint, each of the first active pattern AP1 and the second active pattern AP2 may have a parallelogram shape or a rhombic shape. Since the first active pattern AP1 and the second active pattern AP2 are arranged in the diagonal direction, it is possible to reduce coupling between the first active pattern AP1 and the second active pattern AP2 facing each other in the second direction DR2.

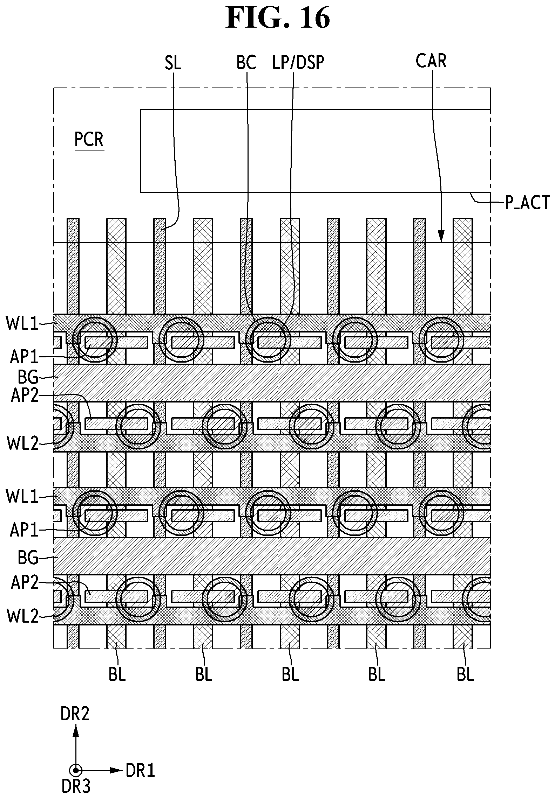

Referring to FIG. 16, in the semiconductor device according to some embodiments, the landing pads LP and the data storage patterns DSP may be arranged in a zigzag or honeycomb shape from a planar viewpoint.

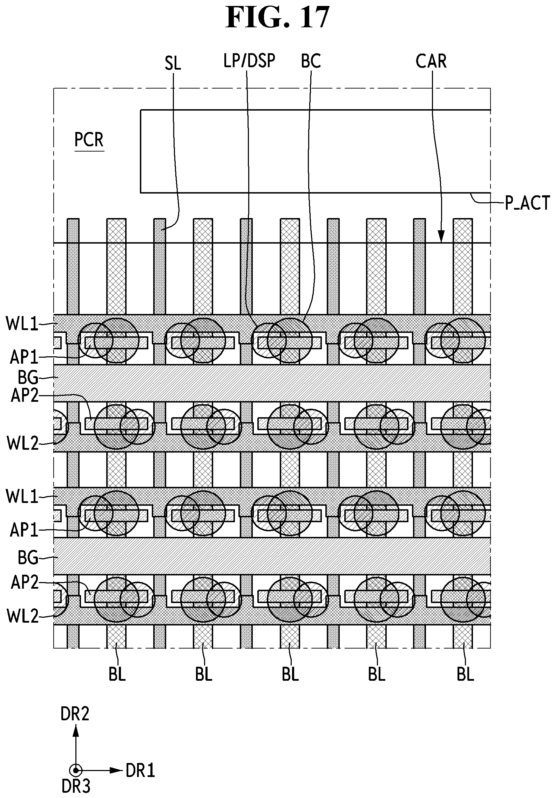

Referring to FIG. 17, in the semiconductor device according to some embodiments, the data storage patterns DSP may be disposed to be offset from the landing pads LP from a planar viewpoint.

Each data storage pattern DSP may be in contact with a part of the landing pad LP.

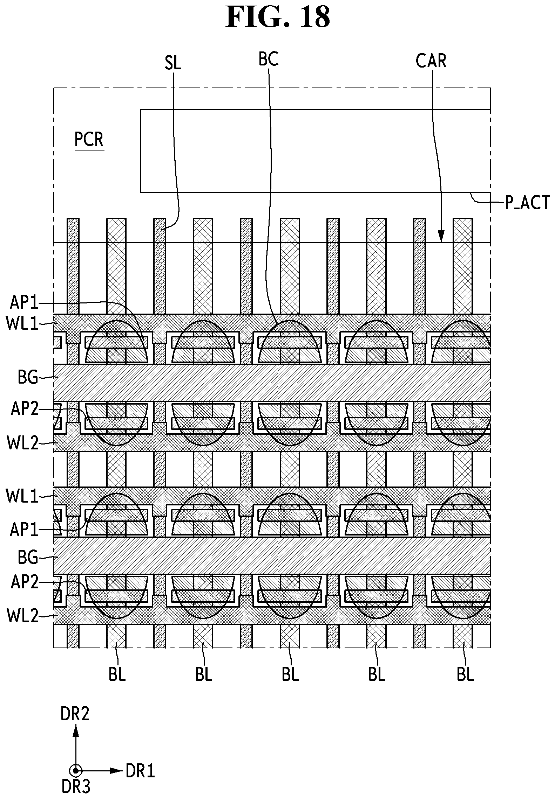

Referring to FIG. 18, in the semiconductor device according to some embodiments, each of the contact patterns BC disposed on the first active pattern AP1 and the second active pattern AP2 may have a semicircular shape or a semielliptical shape from a planar viewpoint.

The contact patterns BC may be disposed symmetrically with the back gate electrode BG interposed therebetween from a planar viewpoint.

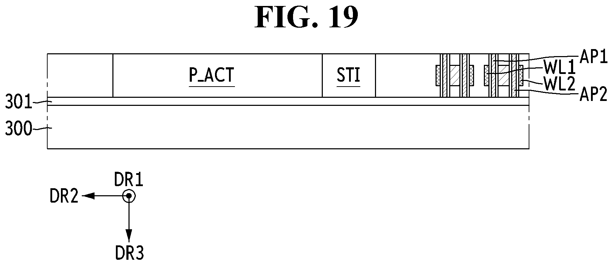

FIGS. 19 to 26 are intermediate stage diagrams for explaining a method for fabricating a semiconductor device according to some embodiments. Accordingly, the semiconductor device explained referring to FIGS. 1 to 10 may be fabricated.

Referring to FIG. 19, a sub-substrate structure including a sub-substrate 300, a buried insulating layer 301, and an active layer may be provided.

For example, the sub-substrate structure may be a silicon-on-insulator substrate (i.e., SOI substrate).

The sub-substrate 300 may include a cell array region (see CAR of FIG. 2) and a peripheral circuit region (see PCR of FIG. 2). The sub-substrate 300 may be, for example, a silicon substrate, a germanium substrate, and/or a silicon-germanium substrate.

The buried insulating layer 301 may be a buried oxide (BOX) formed by a SIMOX (separation by implanted oxygen) method or a bonding and layer transfer method. In other embodiments, the buried insulating layer 301 may be an insulating film formed by a chemical vapor deposition (CVD). The buried insulating layer 301 may include, for example, a silicon oxide film, a silicon nitride film, a silicon oxynitride film, and/or a low dielectric constant insulating film.

The active layer may be a single crystal semiconductor film. The active layer may be, for example, a single crystal silicon substrate, a germanium substrate, and/or a silicon-germanium substrate.

A peri-field insulating film STI may be formed on the sub-substrate 300. The peri-field insulating film STI may be formed in the active layer. The peri-field insulating film STI may be formed to define a cell array region (see CAR of FIG. 2). In addition, the peri-field insulating film STI may be formed to form a peri-active pattern P_ACT.

Next, a first active pattern AP1, a second active pattern AP2, a first word line WL1, and a second word line WL2 may be formed in the cell array region CAR.

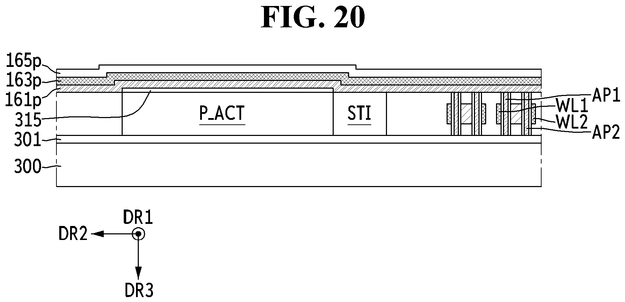

Referring to FIG. 20, a second peri-gate insulating film 315 may be formed on the peri-active pattern P_ACT. The semiconductor film 161p, the metal film 163p and the mask film 165p may be sequentially formed on the second peri-gate insulating film 315.

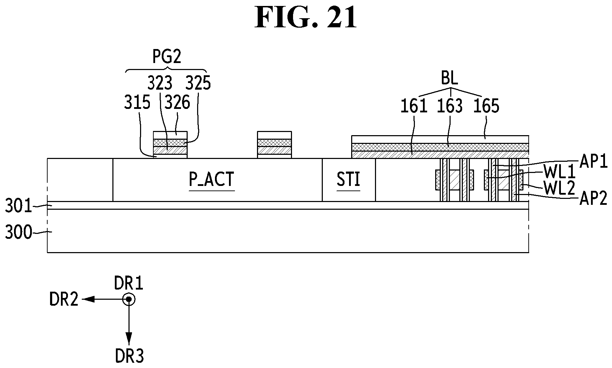

Referring to FIGS. 20 and 21, the semiconductor film 161p, the metal film 163p and the mask film 165p may be patterned, and the bit line BL may be formed on the first active pattern AP1 and the second active pattern AP2.

The second peri-gate insulating film 315, the semiconductor film 161p, the metal film 163p and the mask film 165p may be patterned, and the second peri-gate structure PG2 may be formed on the peri-active pattern P_ACT.

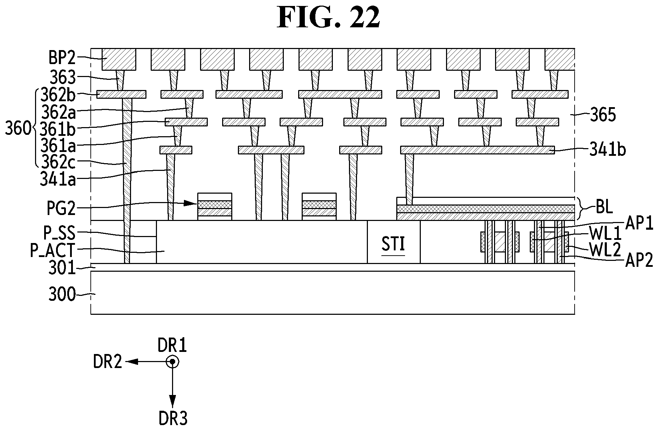

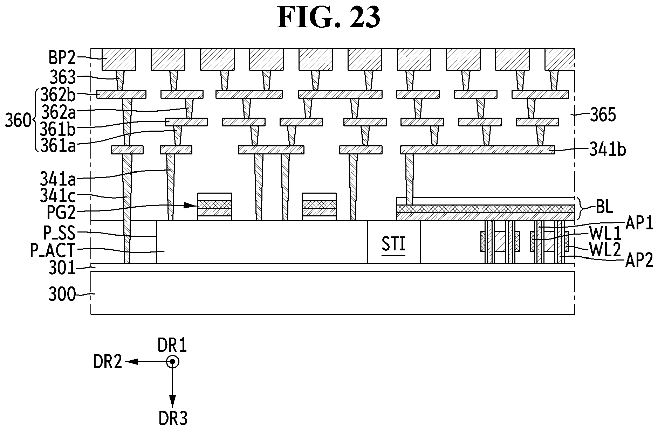

Referring to FIGS. 22 and 23, the second peri-contact plug 341a and the second peri-wiring line 341b may be formed on the second peri-gate structure PG2 and the bit line BL.

Next, the second peri-connecting structure 360 may be formed on the second peri-wiring line 341b. A second bonding pad BP2 and a second bonding pad plug 363 may be formed on the second peri-connecting structure 360.

In FIG. 22, a first peri-through via 362c penetrating the peri-field insulating film STI may be formed, while forming the second peri-connecting structure 360.

In FIG. 23, a second peri-field through plug 341c penetrating the peri-field insulating film STI may be formed, while forming the second peri-contact plug 341a.

The following fabricating method will be described as proceeding after FIG. 22.

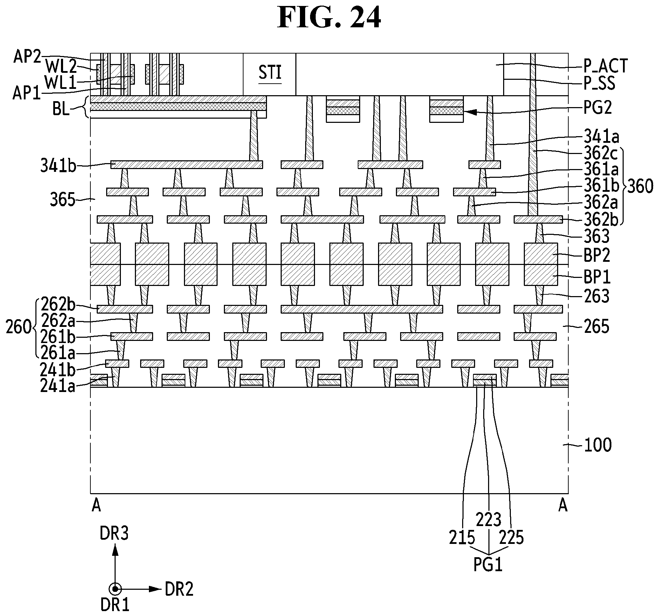

Referring to FIG. 24, the first peri-gate structure PG1, the first peri-connecting structure 260, and the first bonding pad BP1 may be formed on the first substrate 100.

A sub-substrate 300 on which the second peri-gate structure PG2, the bit line BL, the first active pattern AP1, the second active pattern AP2, the first word line WL1, and the second word line WL2 are formed may be bonded to the first substrate 100. The first substrate 100 and the sub-substrate 300 may be bonded such that the first peri-gate structure PG1 and the second peri-gate structure PG2 face each other. The first bonding pad BP1 and the second bonding pad BP2 may be connected to bond the sub-substrate 300 to the first substrate 100.

Next, after bonding the first substrate 100 and the sub-substrate 300, a back surface lapping process of removing the sub-substrate 300 and the buried insulating layer 301 may be performed. The sub-substrate 300 and the buried insulating layer 301 may be removed to expose the first peri-through via 362c.

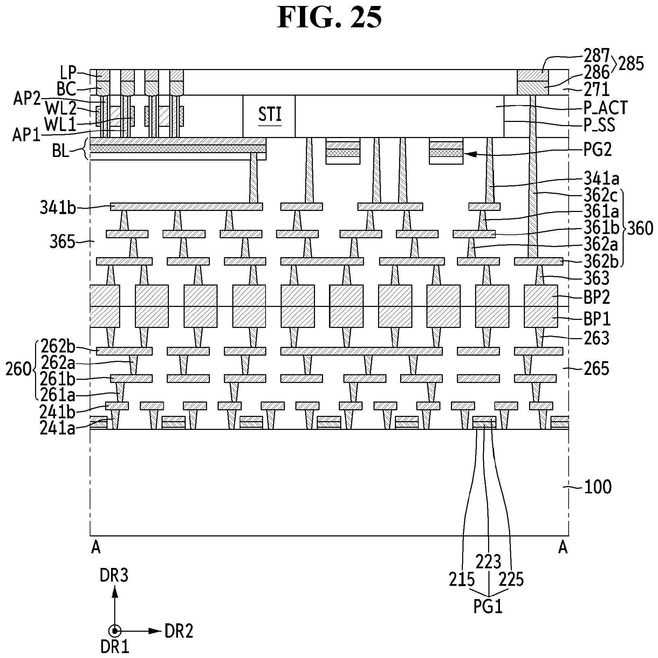

Referring to FIG. 25, a contact pattern BC and a landing pad LP may be formed in the first interlayer insulating film 271.

The contact pattern BC may be connected to the first active pattern AP1 and the second active pattern AP2.

The connecting buffer conductive pattern 285 may be formed in the first interlayer insulating film 271. The connecting buffer conductive pattern 285 may be connected to the exposed first peri-through via 362c.

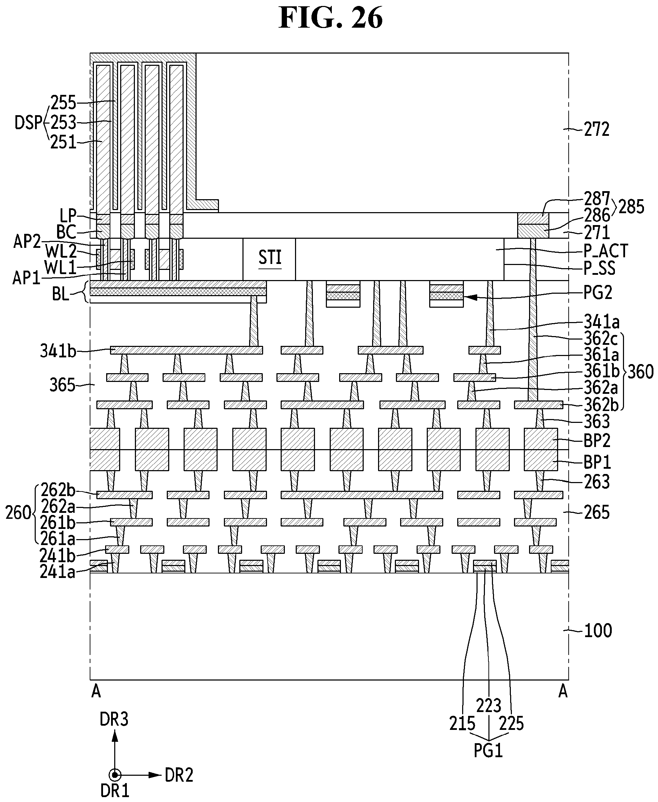

Referring to FIG. 26, a data storage pattern DSP may be formed on the contact pattern BC. The data storage pattern DSP may be connected to the first active pattern AP1 and the second active pattern AP2.

Then, a second interlayer insulating film 272 may be formed on the first interlayer insulating film 271.

Next, referring back to FIG. 3, a connecting pad 280 may be formed on the data storage pattern DSP.

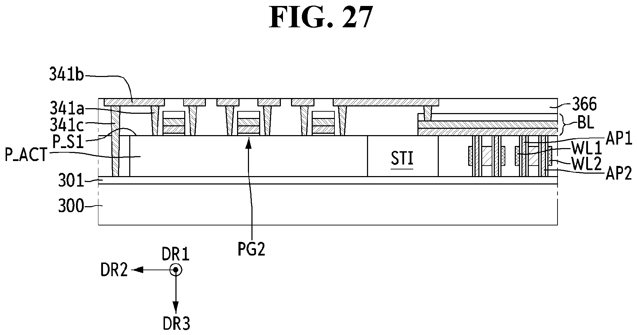

FIGS. 27 to 30 are intermediate stage diagrams for explaining a method for fabricating a semiconductor device according to some embodiments. The semiconductor device described referring to FIGS. 13 and 14 may be fabricated, accordingly.

For reference, FIG. 27 may be a fabricating process that proceeds after FIG. 21. Referring to FIG. 27, the second peri-contact plug 341a and the second peri-wiring line 341b may be formed on the second peri-gate structure PG2 and the bit line BL.

The second peri-contact plug 341a and the second peri-wiring line 341b may be formed in the lower peri-interlayer insulating film 366. The lower peri-interlayer insulating film 366 may be on (e.g., may cover) the bit line BL and the second peri-gate structure PG2. During the formation of the second peri-contact plug 341a, the second peri-field through plug 341c may be formed in the peri-field insulating film STI and the lower interlayer insulating film 366.

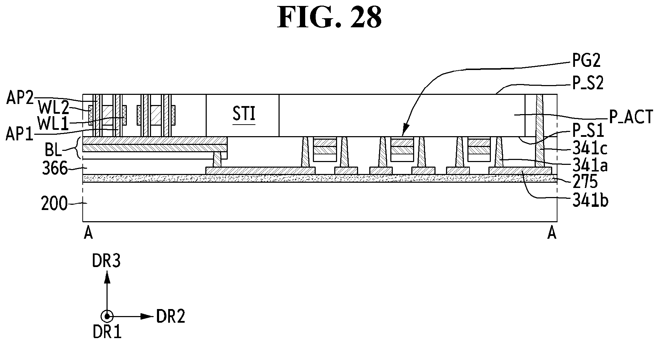

Referring to FIG. 28, the sub-substrate 300 on which the second peri-gate structure PG2, the bit line BL, the first active pattern AP1, the second active pattern AP2, the first word line WL1, and the second word line WL2 are formed may be bonded to the second substrate 200.

The sub-substrate 300 may be bonded to the second substrate 200, using the bonding insulating film 275.

Then, after bonding the second substrate 200 and the sub-substrate 300, a back surface lapping process of removing the sub-substrate 300 and the buried insulating layer 301 may be performed. The sub-substrate 300 and the buried insulating layer 301 are removed, and the second peri-field through plug 341c may be exposed.

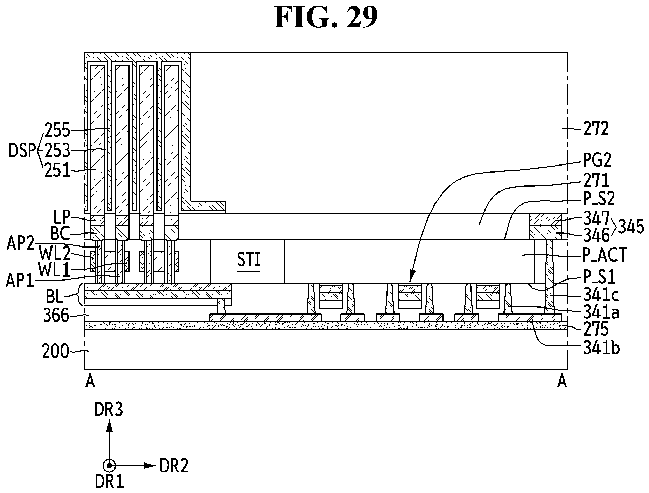

Referring to FIG. 29, the contact pattern BC and the landing pad LP may be formed in the first interlayer insulating film 271.

The connecting buffer conductive pattern 345 may be formed in the first interlayer insulating film 271. The connecting buffer conductive pattern 345 may be connected to the exposed second peri-field through plug 341c.

Next, the data storage pattern DSP may be formed on the contact pattern BC and the connecting buffer conductive pattern 345. The data storage pattern DSP may be connected to the first active pattern AP1 and the second active pattern AP2.

Next, the second interlayer insulating film 272 may be formed on the first interlayer insulating film 271.

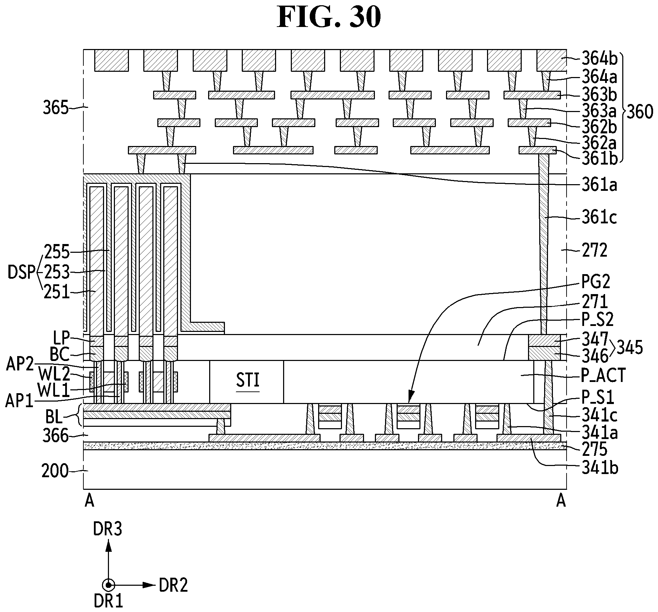

Referring to FIG. 30, a second peri-connecting structure 360 may be formed on the data storage pattern DSP.

The second peri-connecting structure 360 may be connected to the data storage pattern DSP. The second peri-connecting structure 360 may be connected to the connecting buffer conductive pattern 345.

Next, referring back to FIG. 13, a connecting pad 280 may be formed on the second peri-connecting structure 360.

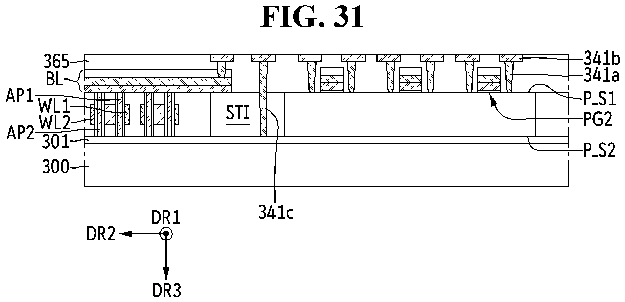

FIGS. 31 to 34 are intermediate stage diagrams for explaining a method for fabricating a semiconductor device according to some embodiments. The semiconductor device described referring to FIGS. 11 and 12 may be fabricated, accordingly.

For reference, FIG. 31 may be a fabricating process that proceeds after FIG. 21.

Referring to FIG. 31, a second peri-contact plug 341a and a second peri-wiring line 341b may be formed on the second peri-gate structure PG2 and the bit line BL.

The second peri-contact plug 341a and the second peri-wiring line 341b may be formed in the second peri-interlayer insulating film 365. During the formation of the second peri-contact plug 341a, a second peri-field through plug 341c may be formed in the peri-field insulating film STI and the second peri-interlayer insulating film 365.

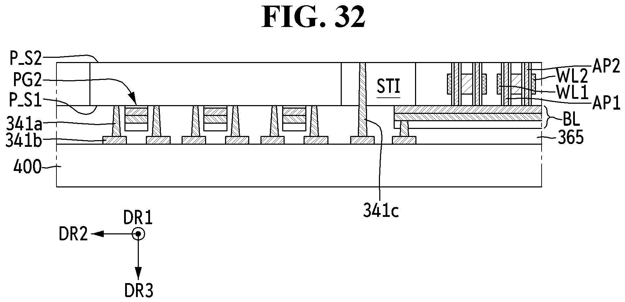

Referring to FIG. 32, the sub-substrate 300 on which the second peri-gate structure PG2, the bit line BL, the first active pattern AP1, the second active pattern AP2, the first word line WL1 and the second word line WL2 are formed may be bonded to a supporting substrate 400.

Next, after bonding the supporting substrate 400 and the sub-substrate 300, the sub-substrate 300 and the buried insulating layer 301 may be removed to expose the second peri-field through plug 341c.

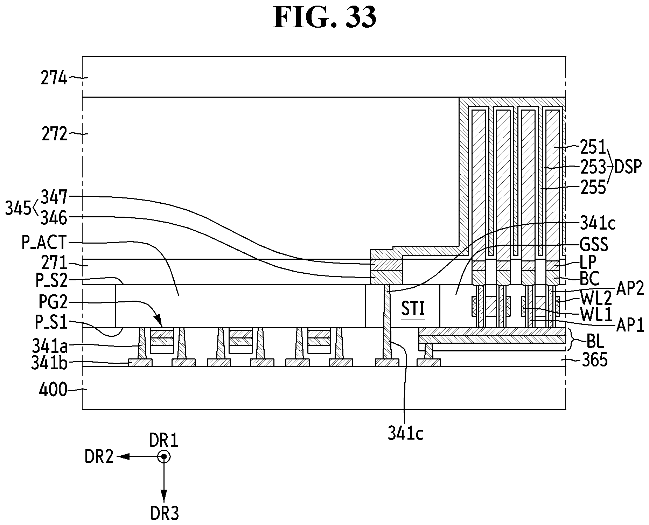

Referring to FIG. 33, the contact pattern BC, the landing pad LP, and the connecting buffer conductive pattern 345 may be formed in the first interlayer insulating film 271.

Then, the data storage pattern DSP may be formed on the contact pattern BC and the connecting buffer conductive pattern 345.

The fourth interlayer insulating film 274 may be formed on the data storage pattern DSP.

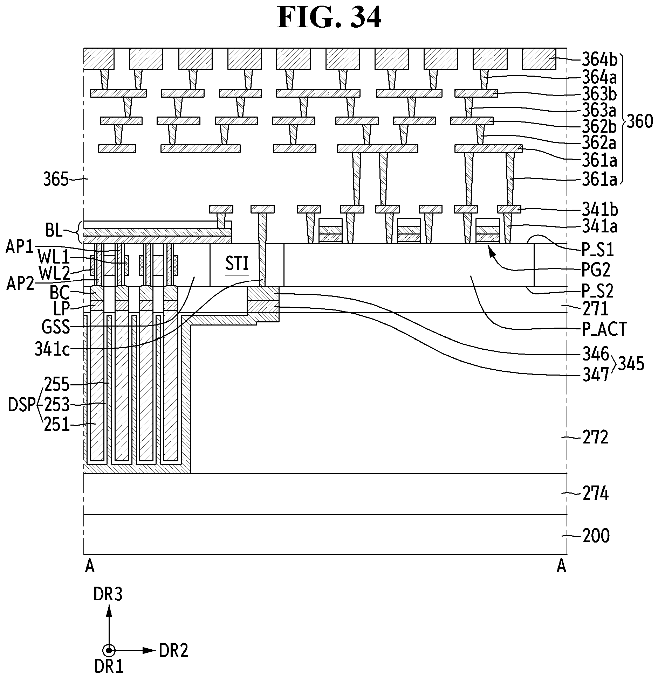

Referring to FIG. 34, the supporting substrate 400 on which the data storage pattern DSP, the second peri-gate structure PG2, the bit line BL, the first active pattern AP1, the second active pattern AP2, the first word line WL1, and the second word line WL2 are disposed may be bonded to the second substrate 200.

After bonding the second substrate 200 and the supporting substrate 400, the supporting substrate 400 may be removed.

After removing the supporting substrate 400, a second peri-connecting structure 360 may be formed on the second peri-wiring line 341b.

Next, referring back to FIG. 11, a connecting pad 280 may be formed on the second peri-connecting structure 360.

Although example embodiments of the present disclosure have been described with reference to the accompanying drawings, the present disclosure is not limited to the above embodiments, but may be implemented in various different forms. A person skilled in the art will appreciate that the present disclosure may be practiced in other concrete forms without changing the scope of the present disclosure. Therefore, it should be appreciated that the embodiments as described above are not restrictive but illustrative in all respects.

As used herein, the terms "comprises", "comprising", "includes", "including", "has", "having" and any other variations thereof specify the presence of the stated features, steps, operations, elements, components, and/or groups but do not preclude the presence or addition of one or more other features, steps, operations, elements, components, and/or groups thereof. In addition, it will be understood that, although the terms "first", "second", "third", etc. may be used herein to describe various elements, these elements should not be limited by these terms. Rather, these terms are only used to distinguish one element from another. For example, a first element could be termed a second element, and, similarly, a second element could be termed a first element, without departing from the scope of the present disclosure.

Embodiments are set out in the following clauses:
Clause 1. A semiconductor device comprising: an active pattern that includes a first surface and a second surface opposite to each other in a first direction; a peri-active pattern that includes a first surface and a second surface opposite to each other in the first direction, wherein the peri-active pattern is spaced apart from the active pattern in a second direction intersecting the first direction; a bit line that is electrically connected to the first surface of the active pattern and extends in the second direction; a data storage pattern electrically connected to the second surface of the active pattern; and a first peri-gate structure on the first surface of the peri-active pattern.
Clause 2. The semiconductor device of clause 1, further comprising: a peri-field insulating film in contact with a sidewall of the peri-active pattern, wherein the sidewall of the peri-active pattern connects the first surface of the peri-active pattern to the second surface of the peri-active pattern; a peri-contact plug electrically connected to the first peri-gate structure; a peri-field through plug extending into the peri-field insulating film; and a peri-wiring line on the first surface of the peri-active pattern and electrically connected to the peri-contact plug and the peri-field through plug.
Clause 3. The semiconductor device of clause 2, further comprising a peri-connecting structure on the first surface of the peri-active pattern and electrically connected to the peri-wiring line.
Clause 4. The semiconductor device of clause 2 or 3, wherein the peri-field through plug is electrically connected to the data storage pattern.
Clause 5. The semiconductor device of clause 2, 3 or 4, further comprising a peri-connecting structure on the second surface of the peri-active pattern and electrically connected to the data storage pattern, wherein the peri-field through plug is electrically connected to the peri-connecting structure.
Clause 6. The semiconductor device of clause 5, further comprising a connecting buffer conductive pattern on the second surface of the peri-active pattern, wherein the peri-connecting structure and the peri-field through plug are electrically connected to the connecting buffer conductive pattern.
Clause 7. The semiconductor device of any preceding clause, further comprising: a substrate that is spaced apart from the active pattern and the peri-active pattern in the first direction; and a second peri-gate structure on the substrate.
Clause 8. The semiconductor device of clause 7, wherein the first surface of the peri-active pattern faces the substrate.
Clause 9. The semiconductor device of clause 7 or 8, further comprising: a first peri-connecting structure electrically connected to the first peri-gate structure; a first bonding pad electrically connected to the first peri-connecting structure; a second peri-connecting structure electrically connected to the second peri-gate structure; and a second bonding pad electrically connected to the second peri-connecting structure and the first bonding pad.
Clause 10. The semiconductor device of clause 7, 8 or 9, further comprising: a first peri-connecting structure on the first surface of the peri-active pattern and electrically connected to the first peri-gate structure; and a connecting pad on the second surface of the peri-active pattern, wherein the connecting pad is electrically connected to the data storage pattern and the first peri-connecting structure.
Clause 11. The semiconductor device of clause 10, further comprising: a connecting buffer conductive pattern on the second surface of the peri-active pattern; and a connecting pad connection plug that electrically connects the connecting buffer conductive pattern to the connecting pad, wherein the first peri-connecting structure is electrically connected to the connecting buffer conductive pattern.
Clause 12. The semiconductor device of any preceding clause, wherein the bit line includes a conductive bit line comprising a conductive material, wherein the first peri-gate structure includes a first peri-gate electrode, and wherein a thickness of the conductive bit line is equal to a thickness of the first peri-gate electrode.
Clause 13. A semiconductor device comprising: a first peri-gate structure on a substrate; an active pattern that is spaced apart from the substrate in a first direction and includes a first surface and a second surface opposite to each other in the first direction; a peri-active pattern that is spaced apart from the substrate in the first direction and includes a first surface and a second surface opposite to each other in the first direction; a second peri-gate structure on the first surface of the peri-active pattern; a bit line that is electrically connected to the first surface of the active pattern and extends in a second direction intersecting the first direction; and a data storage pattern electrically connected to the second surface of the active pattern.
Clause 14. The semiconductor device of clause 13, wherein the first surface of the active pattern and the first surface of the peri-active pattern face the substrate.
Clause 15. The semiconductor device of clause 13 or 14, further comprising: a peri-connecting structure on the first surface of the peri-active pattern and electrically connected to the second peri-gate structure; a connecting pad on the second surface of the peri-active pattern; a connecting buffer conductive pattern on the second surface of the peri-active pattern; and a connecting pad connection plug that electrically connects the connecting buffer conductive pattern to the connecting pad, wherein the connecting buffer conductive pattern is electrically connected to the peri-connecting structure.
Clause 16. The semiconductor device of clause 15, wherein the peri-connecting structure is in contact with the connecting buffer conductive pattern.
Clause 17. The semiconductor device of clause 15 or 16, comprising: a peri-field insulating film in contact with a side wall of the peri-active pattern, wherein the sidewall of the peri-active pattern connects the first surface of the peri-active pattern and the second surface of the peri-active pattern; a peri-contact plug electrically connected to the second peri-gate structure; a peri-field through plug that extends into the peri-field insulating film, and is electrically connected to the connecting buffer conductive pattern; and a peri-wiring line which is disposed on the first surface of the peri-active pattern, and electrically connected to the peri-contact plug and the peri-field through plug.
Clause 18. The semiconductor device of any one of clauses 13 to 17, further comprising: a first peri-connecting structure electrically connected to the first peri-gate structure; a first bonding pad electrically connected to the first peri-connecting structure; a second peri-connecting structure on the first surface of the peri-active pattern and electrically connected to the second peri-gate structure; and a second bonding pad electrically connected to the second peri-connecting structure and connected to the first bonding pad.
Clause 19. A semiconductor device comprising: an active pattern that is spaced apart from a substrate in a first direction, and includes a first surface and a second surface opposite to each other in the first direction; a peri-active pattern that is spaced apart from the substrate in the first direction, and includes a first surface and a second surface opposite to each other in the first direction, the second surface of the peri-active pattern being spaced apart from the substrate; a bit line that is electrically connected to the first surface of the active pattern, extends in a second direction intersecting the first direction, and includes a conductive bit line comprising a conductive material; a data storage pattern electrically connected to the second surface of the active pattern; a peri-gate structure that is disposed on the first surface of the peri-active pattern, and includes a peri-gate electrode, wherein a thickness of the peri-gate electrode being is equal to a thickness of the conductive bit line; a peri-field insulating film which is in contact with a side wall of the peri-active pattern, wherein the sidewall of the peri-active pattern connects the first surface of the peri-active pattern and the second surface of the peri-active pattern; a peri-contact plug electrically connected to the peri-gate structure; a peri-field through plug that extends into the peri-field insulating film; a peri-wiring line which is disposed on the first surface of the peri-active pattern, and electrically connected to the peri-contact plug and the peri-field through plug; and a peri-connecting structure which is disposed on the substrate, and electrically connected to the peri-wiring line.
Clause 20. The semiconductor device of clause 19, further comprising a connecting buffer conductive pattern disposed on the second surface of the peri-active pattern, wherein the peri-connecting structure and the peri-field through via plug are electrically connected to the connecting buffer conductive pattern.

## Claims

1. A semiconductor device comprising:
an active pattern that includes a first surface and a second surface opposite to each other in a first direction;
a peri-active pattern that includes a first surface and a second surface opposite to each other in the first direction, wherein the peri-active pattern is spaced apart from the active pattern in a second direction intersecting the first direction;
a bit line that is electrically connected to the first surface of the active pattern and extends in the second direction;
a data storage pattern electrically connected to the second surface of the active pattern; and
a first peri-gate structure on the first surface of the peri-active pattern.

2. The semiconductor device of claim 1, further comprising:
a peri-field insulating film in contact with a sidewall of the peri-active pattern, wherein the sidewall of the peri-active pattern connects the first surface of the peri-active pattern to the second surface of the peri-active pattern;
a peri-contact plug electrically connected to the first peri-gate structure;
a peri-field through plug extending into the peri-field insulating film; and
a peri-wiring line on the first surface of the peri-active pattern and electrically connected to the peri-contact plug and the peri-field through plug.

3. The semiconductor device of claim 2, further comprising a peri-connecting structure on the first surface of the peri-active pattern and electrically connected to the peri-wiring line.

4. The semiconductor device of claim 2 or 3, wherein the peri-field through plug is electrically connected to the data storage pattern.

5. The semiconductor device of claim 2, 3 or 4, further comprising a peri-connecting structure on the second surface of the peri-active pattern and electrically connected to the data storage pattern,
wherein the peri-field through plug is electrically connected to the peri-connecting structure.

6. The semiconductor device of claim 5, further comprising a connecting buffer conductive pattern on the second surface of the peri-active pattern,
wherein the peri-connecting structure and the peri-field through plug are electrically connected to the connecting buffer conductive pattern.

7. The semiconductor device of any preceding claim, further comprising:
a substrate that is spaced apart from the active pattern and the peri-active pattern in the first direction; and
a second peri-gate structure on the substrate.

8. The semiconductor device of claim 7, wherein the first surface of the peri-active pattern faces the substrate.

9. The semiconductor device of claim 7 or 8, further comprising:
a first peri-connecting structure electrically connected to the first peri-gate structure;
a first bonding pad electrically connected to the first peri-connecting structure;
a second peri-connecting structure electrically connected to the second peri-gate structure; and
a second bonding pad electrically connected to the second peri-connecting structure and the first bonding pad.

10. The semiconductor device of claim 7, 8 or 9, further comprising:
a first peri-connecting structure on the first surface of the peri-active pattern and electrically connected to the first peri-gate structure; and
a connecting pad on the second surface of the peri-active pattern,
wherein the connecting pad is electrically connected to the data storage pattern and the first peri-connecting structure.

11. The semiconductor device of claim 10, further comprising:
a connecting buffer conductive pattern on the second surface of the peri-active pattern; and
a connecting pad connection plug that electrically connects the connecting buffer conductive pattern to the connecting pad,
wherein the first peri-connecting structure is electrically connected to the connecting buffer conductive pattern.

12. The semiconductor device of any preceding claim, wherein the bit line includes a conductive bit line comprising a conductive material,
wherein the first peri-gate structure includes a first peri-gate electrode, and
wherein a thickness of the conductive bit line is equal to a thickness of the first peri-gate electrode.

13. The semiconductor device of claim 1, further comprising:
a second peri-gate structure on a substrate;
wherein the active pattern is spaced apart from the substrate in a first direction and
the peri-active pattern is spaced apart from the substrate in the first direction.

14. The semiconductor device of claim 13, wherein the first surface of the active pattern and the first surface of the peri-active pattern face the substrate.

15. The semiconductor device of claim 13 or 14, further comprising:
a peri-connecting structure on the first surface of the peri-active pattern and electrically connected to the first peri-gate structure;
a connecting pad on the second surface of the peri-active pattern;
a connecting buffer conductive pattern on the second surface of the peri-active pattern; and
a connecting pad connection plug that electrically connects the connecting buffer conductive pattern to the connecting pad,
wherein the connecting buffer conductive pattern is electrically connected to the peri-connecting structure.
